(19) Europäisches Patentamt / European Patent Office / Office européen des brevets

(11) EP 2 544 016 B1

(12) **EUROPEAN PATENT SPECIFICATION**

(45) Date of publication and mention
of the grant of the patent:
**15.04.2020 Bulletin 2020/16**

(21) Application number: **11750653.5**

(22) Date of filing: **01.03.2011**

(51) Int Cl.:
*G01R 33/02* (2006.01)  *A61B 5/055* (2006.01)
*G01R 29/14* (2006.01)  *G01R 33/34* (2006.01)
*G01N 24/08* (2006.01)  *G01R 33/10* (2006.01)
*G01R 33/38* (2006.01)

(86) International application number:
**PCT/JP2011/054635**

(87) International publication number:
**WO 2011/108543 (09.09.2011 Gazette 2011/36)**

(54) **DEVICE AND METHOD FOR OBTAINING A POTENTIAL**

VORRICHTUNG UND VERFAHREN ZUR ERMITTLUNG EINES POTENTIALS

DISPOSITIF ET PROCÉDÉ D'OBTENTION DE POTENTIEL

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **01.03.2010 JP 2010044218**

(43) Date of publication of application:
**09.01.2013 Bulletin 2013/02**

(73) Proprietor: **KIMURA, Kenjiro
Hyogo 657-8501 (JP)**

(72) Inventor: **KIMURA, Kenjiro
Hyogo 657-8501 (JP)**

(74) Representative: **Müller-Boré & Partner
Patentanwälte PartG mbB
Friedenheimer Brücke 21
80639 München (DE)**

(56) References cited:
**WO-A1-2008/123432      JP-A- 3 090 877
JP-A- 4 098 159      JP-A- 9 243 725
JP-A- H0 493 783      JP-A- 2007 271 465
US-A1- 2005 116 713**

• **BLUMICH B ET AL: "Mobile single-sided NMR",
PROGRESS IN NUCLEAR MAGNETIC
RESONANCE SPECTROSCOPY, PERGAMON
PRESS, OXFORD, GB, vol. 52, no. 4, 1 May 2008
(2008-05-01), pages 197-269, XP022589395, ISSN:
0079-6565, DOI: 10.1016/J.PNMRS.2007.10.002
[retrieved on 2007-12-28]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**Technical Field**

The present invention relates to a technique for obtaining a two-dimensional potential distribution derived from a magnetic potential, an electric potential, temperature, or the like by measurement.

**Background Art**

Conventionally, the distribution of a magnetic field has been obtained using a superconducting quantum interference device (hereinafter referred to as an "SQUID") or a magnetoresistive sensor, and for example, a defective (or short-circuited) portion of an electric circuit has been specified based on the magnetic field distribution. Since the resolution of the magnetic field measurement depends on the size of the SQUID coil or the magnetoresistive sensor, attempts are being made to reduce that size in order to improve the resolution of the measurement.

Obtaining the spatial distribution of a magnetic field has also been performed using magnetic force microscopy (hereinafter referred to as "MFM"). Japanese translation of PCT International Application Publication No. 2006-501484 suggests use of a carbon nanotube including a nanoscale ferromagnetic material as a cantilever in the MFM.

WO/2008/123432 (Document 2) discloses a technique for obtaining a three-dimensional potential distribution. With this technique, a magnetic force distribution on a specific measurement plane is obtained as a two-dimensional magnetic field distribution image, using an MFM above a sample having magnetic domains. An auxiliary magnetic field distribution image is also obtained by performing measurement on another measurement plane that is away from the above measurement plane by a small distance d, and a difference between these images is divided by the small distance d so as to obtain a two-dimensional magnetic field gradient distribution image. The magnetic field distribution image and the magnetic field gradient distribution image are Fourier transformed and substituted into a three-dimensional potential distribution obtaining equation derived from the general solution of the Laplace equation. It is thus possible to obtain an image that indicates a three-dimensional magnetic field distribution with high precision.

Incidentally, there is a limit to miniaturization of the SQUID coil or the magnetoresistive sensor because of the wavelength used in exposure technology, and thus there is also a certain limit to improvement in the resolution of the measurement. Moreover, although the radius of curvature of the tip of a silicon probe formed by anisotropic etching can be reduced to an extremely small value as small as several nanometers, it is necessary, when using the silicon probe in an MFM, to form a thin film of a magnetic material on the tip of the probe. This makes a magnetic force sensor that has a thickness equal to the "film thickness of the magnetic thin film + radius of curvature of the tip of the probe + the magnetic thin film". For example, if the film thickness of the magnetic thin film is 10 nm and the radius of curvature of the tip of the probe is 10 nm, the magnetic force sensor has a total diameter of 30 nm. At least there are no cases where the resolution of the measurement exceeds the radius of curvature of the tip of the probe. In addition, since it is difficult in practical use to cover only the tip portion of the probe with the magnetic thin film, the size of the effective magnetic force sensor is further increased.

JP 2007 271465 A solves the problem of providing a magnetic field distribution measuring instrument that has high resolution and that simplifies the position control of a probe. The solution is a magnetic field distribution measuring instrument which comprises the probe having a thin-film magnetometric sensor for detecting magnetic field distribution very close to a measured object as an output signal of voltage or current, an actuator for one-dimensionally translation-scanning the probe in the thickness direction of the thin-film magnetometric sensor, a rotating mechanism for making the measured object rotate in the horizontal plane, an angle sensor for detecting the rotation angle of the measured object, and a magnetic field distribution reconstructing means for reconstructing the magnetic field distribution, based on the output signal from the probe, the position signal of the probe output from the actuator, and a rotation angle signal output from the angle sensor.

The problem of the present application is therefore related to improving the resolution of universal two-dimensional potential measurements and calculating the three-dimensional potentials formed at least in the periphery of an object.

This problem is solved by the independent claims. Preferred embodiments are given by the dependent claims.

**Summary of Invention**

An object of the present invention is to improve the resolution of measurement of a two-dimensional potential (two-dimensional potential distribution) derived from a magnetic potential, an electric potential, temperature field, or the like. This object is achieved with a potential obtaining apparatus and a method in accordance with claims 1 and 7, respectively.

The present invention is intended for a potential obtaining apparatus for, assuming that $\varphi(x, y, z)$ is a potential function that indicates a three-dimensional potential formed at least in the periphery of an object due to the presence of the object (where x, y, and z are coordinate parameters of a rectangular coordinate system defined in mutually perpendicular X, Y, and Z directions that are set for the object), obtaining $\varphi(x, y, \alpha)$ on a measurement plane that is set outside the object and satisfies $z = \alpha$ (where $\alpha$ is an arbitrary value). The apparatus includes a measurement unit in which a plurality of linear areas that extend in a longitudinal direction parallel to the measurement plane that is parallel to an XY plane are set so as to be arranged in an X' direction perpendicular to the longitudinal direction on the measurement plane, and that is for obtaining a measured value derived from the three-dimensional potential in each of the plurality of linear areas in a state in which an angle $\theta$ formed by the Y direction and the longitudinal direction has been changed to a plurality of angles, and a computing part for, assuming that x' is a coordinate parameter in the X' direction (where an origin is on a Z axis), obtaining $\varphi(x, y, \alpha)$ from Equation 1 using the measured values f(x', $\theta$) obtained by the measurement unit,

[Equation 1]

$$\phi(x,y,\alpha) = \iint \left[ \int f(x',\theta) exp(-ik_{x'}x')dx' \right] exp(ik_{x'}(x\cos\theta + y\sin\theta))k_{x'}dk_{x'}d\theta$$

(where $k_{x'}$ is a wavenumber in the X' direction).

According to the present invention, the measurement unit includes a measuring part that extends in the longitudinal direction and is for obtaining a measured value derived from the three-dimensional potential, an angle changing part for changing the angle $\theta$ formed by the reference direction and the longitudinal direction of the measuring part, a moving mechanism for moving the measuring part in the X' direction relative to the object on the measurement plane such that scanning is performed in which the measuring part passes through over a measurement area of the object, and a control part for controlling the angle changing part and the moving mechanism such that the scanning is repeated while the angle $\theta$ is changed to a plurality of angles. The measurement unit obtains measured values f(x', $\theta$) by repetitions of the scanning.

Preferably, the three-dimensional potential is a potential derived by differentiating a magnetic potential once or more times with respect to the Z direction, and the measuring part is a thin-film element that spreads in the longitudinal direction and the Z direction and generates a signal derived from the three-dimensional potential. In this case, the resolution of measurement in the scanning direction during scanning with the measuring part can be improved.

According to the present invention, the potential obtaining apparatus further includes another moving mechanism for moving the measuring part in the Z direction relative to the object. The three-dimensional potential satisfies the Laplace equation. The control part obtains $\varphi(x, y, 0)$ on the measurement plane that satisfies $z = 0$ as a two-dimensional first image, and after the measuring part is moved by a small distance in the Z direction relative to the object, obtains a two-dimensional intermediate image using a technique similar to that used to obtain the first image. The computing part obtains a difference image between the first image and the intermediate image, divides the difference image by the small distance so as to obtain a differential image as a second image, Fourier transforms $\varphi(x, y, 0)$ serving as the first image and $\varphi_z(x, y, 0)$ serving as the second image so as to obtain $\psi(k_x, k_y)$ and $\psi_z(k_x, k_y)$ (where $k_x$ and $k_y$ are respectively wavenumbers in the X direction and the Y direction), and then obtains $\varphi(x, y, z)$ from Equation 2 using $\psi(k_x, k_y)$ and $\psi_z(k_x, k_y)$.

[Equation 2]

$$\phi(x,y,z)$$
$$= \iint exp(ik_x x + ik_y y)\left\{ \frac{1}{2}\left[ \phi(k_x,k_y) + \frac{\phi_z(k_x,k_y)}{\sqrt{k_x^2+k_y^2}} \right] exp(z\sqrt{k_x^2+k_y^2}) \right.$$
$$\left. + \frac{1}{2}\left[ \phi(k_x,k_y) - \frac{\phi_z(k_x,k_y)}{\sqrt{k_x^2+k_y^2}} \right] exp(-z\sqrt{k_x^2+k_y^2}) \right\} dk_x dk_y$$

It is preferable for the three-dimensional potential to be a potential derived from a magnetic potential, an electric potential, or a temperature field.

The present invention is also intended for a magnetic field microscope using the potential obtaining apparatus described above and for an inspection apparatus using nuclear magnetic resonance. The prevent invention is also intended for a potential obtaining method.

These and other objects, features, aspects and advantages of the present invention will become more apparent from the following detailed description of the present invention when taken in conjunction with the accompanying drawings.

**Brief Description of Drawings**

Fig. 1 is a diagram illustrating the principle of a two-dimensional potential obtaining method;
Fig. 2 shows a configuration of a magnetic field obtaining apparatus;
Fig. 3 shows a configuration of a computer;
Fig. 4 is a block diagram showing a functional configuration realized by the computer;
Fig. 5 is a flowchart of processing for acquiring a two-dimensional potential;
Fig. 6 is a flowchart of processing for acquiring a three-dimensional potential;
Fig. 7 shows a measuring part and a measurement plane;
Fig. 8 shows a condition in which a thin film of a magnetic material is formed on a substrate;
Fig. 9 shows a condition in which a thin film of a magnetic material is formed on a substrate;
Fig. 10 is a diagram illustrating an inspection apparatus;
Fig. 11 shows a functional configuration of a control unit;
Fig. 12 shows part of a magnetic field obtaining apparatus according to a second embodiment;
Fig. 13 shows a configuration of a temperature distribution obtaining apparatus;
Fig. 14 is a bottom view of an element group;
Fig. 15 is a diagram illustrating another example of obtaining a magnetic field distribution image; and
Fig. 16 is a diagram illustrating magnetization of a sample.

**Description of Embodiments**

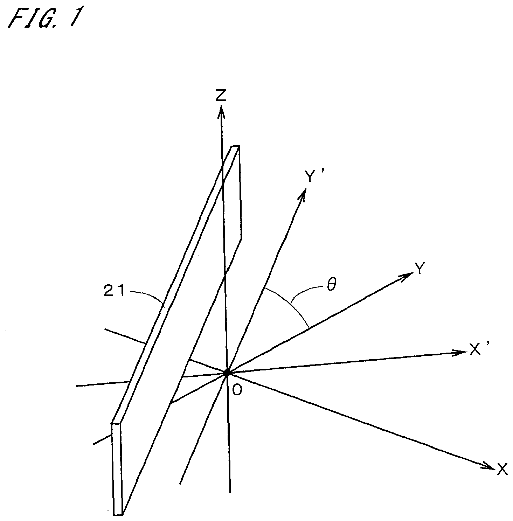

First, the principle of a two-dimensional potential obtaining method according to the present invention will be described. Fig. 1 is a diagram illustrating the principle of the two-dimensional potential obtaining method. A rectangular coordinate system defined by mutually perpendicular X, Y, and Z directions is shown in Fig. 1. In the following description, coordinate parameters in the X, Y, and Z directions are respectively indicated by x, y, and z. A thin film-like measuring part denoted by reference numeral 21 in Fig. 1 extends in a direction parallel to an arbitrary measurement plane (measurement plane parallel to an XY plane) that satisfies $z = \alpha$ (where a is an arbitrary value) on the measurement plane.

In one example of the two-dimensional potential obtaining method according to the present invention, based on the assumption of the presence of a magnetic potential formed at least in the periphery of an object due to the presence of the object, such as a magnetic potential formed by a magnetized magnetic substance in the periphery thereof or a magnetic potential formed by the current flowing inside the semiconductor device in the periphery of (and inside) a multilayer semiconductor device, a two-dimensional potential (potential distribution) on a measurement plane of a three-dimensional potential derived from the magnetic potential is obtained. Specifically, when the measuring part 21 is configured to obtain a Z-directional component of a magnetic field (which may be a magnetic field substantially along the Z direction and is hereinafter also simply referred to as a "magnetic field"), a two-dimensional potential on a measurement plane of a three-dimensional potential where a Z-directional gradient of the magnetic potential $\Phi$ is taken as a scalar value is obtained. That is, if $\Phi(x, y, z)$ is a potential function that indicates a magnetic potential and $\phi(x, y, z)$ is a potential function that indicates the above three-dimensional potential, $\phi(x, y, z)$ is $\Phi_z^{(1)}(x, y, z)$ (hereinafter expressed as $\Phi_z(x, y, z)$) that is derived by differentiating $\Phi(x, y, z)$ once with respect to z, and the two-dimensional potential obtaining method is a method for obtaining $\phi(x, y, \alpha)$ on an arbitrary measurement plane that satisfies $z = \alpha$.

In the following description, it is assumed that a direction parallel to the Y direction on a measurement plane is a reference direction, the longitudinal direction of the measuring part 21 is a Y' direction, a direction perpendicular to the longitudinal direction (Y' direction) on the measurement plane is X' direction, $\theta$ is the angle formed by the reference direction and the Y' direction, and x' and y' are respectively coordinate parameters in the X' direction and the Y' direction (where the origin of the X' and Y' directions is on the Z axis and is the same as the origin of the rectangular coordinate system defined by the X, Y, and Z directions in Fig. 1).

In the two-dimensional potential obtaining method, scanning is performed such that the measuring part 21 is moved in the X' direction so as to pass through a predetermined area on the measurement plane (the area that is obtained by projecting an area to be measured on an object onto the measurement plane and that is hereinafter referred to as a "measurement target area"). During the scanning, a signal indicating a magnetic field received by the measuring part 21 as a whole (a total sum of magnetic lines of force passing through inside the measuring part 21) is generated at each position x' in the X' direction (that is, the measuring part 21 detects a magnetic field and generates an electric signal corresponding to the magnetic field) and is obtained as a measured value. In actuality, scanning in a direction perpendicular to the longitudinal direction is repeated on the measurement plane while changing the angle θ to a plurality of angles in a range of greater than or equal to 0° and less than 180°. As a result, a function f(x', θ) that indicate measured values (hereinafter simply referred to as "measured values f(x', 0)") derived from the three-dimensional potential are obtained, using x' and θ as parameters. Note that the Z axis passes through substantially the center of the measurement target area.

Here, the X'Y' coordinate system when viewed along the Z direction can be considered as a coordinate system obtained by rotating the XY coordinate system by the angle θ about the Z axis. Thus, the following Equation 3 is satisfied.

[Equation 3]

$$\begin{cases} x = x'cos\ \theta - y'sin\ \theta \\ y = x'sin\ \theta + y'cos\ \theta \end{cases}$$

As described previously, during each scan in which the measuring part 21 is moved in the X' direction, a magnetic field received by the measuring part 21 as a whole is obtained. Thus, the measured values f(x', θ) are represented by Equation 4. Note that, in relation to the longitudinal direction (Y' direction) of the measuring part 21, the measuring part 21 is set so as to have a length that is sufficiently longer than the width of the measurement target area.

[Equation 4]

$$f(x',\ \theta) = \int \phi\ (x'cos\,\theta - y'sin\,\theta, x'sin\,\theta + y'cos\,\theta, \alpha\,)\,dy'$$

Here, $\phi(k_x, k_y)|_{z=\alpha}$ (hereinafter simply expressed as $\phi(k_x, k_y)$) obtained by Fourier transforming $\phi(x, y, \alpha)$ with respect to the X and Y directions is represented by Equation 5. In Equation 5, $k_x$ and $k_y$ are respectively wavenumbers in the X and Y directions.

[Equation 5]

$$\phi\ (k_x, k_y) = \iint \phi\ (x, y, \alpha)\,exp(-i\,k_x x - i\,k_y y)\,dx\,dy$$

Substituting ($k_x = k_{x'}cos\theta$), ($k_y = k_{x'}sin\theta$), and (x' = xcosθ + ysinθ) into Equation 5 yields Equation 6. In Equation 6, $k_{x'}$ and $k_{y'}$ are respectively wavenumbers in the X' and Y' directions.

[Equation 6]

$$\phi\ (k_{x'}cos\ \theta, k_{x'}sin\ \theta) = \iint \phi\ (x, y, \alpha)\,exp(-i\,k_{x'}(xcos\ \theta + ysin\ \theta))\,dx\,dy$$

$$= \iint \phi\ (x, y, \alpha)\,exp(-i\,k_{x'}\,x')\,dx\,dy$$

Also, (dxdy) in Equation 6 is represented by Equation 7.

[Equation 7]

$$dxdy = \begin{vmatrix} \cos\theta & -\sin\theta \\ \sin\theta & \cos\theta \end{vmatrix} dx'dy'$$

$$= dx'dy'$$

Accordingly, Equation 6 can be transformed into Equation 8 using Equations 3, 4, and 7. In Equation 8, $\phi$ $(k_x \cdot \cos\theta, k_x \cdot \sin\theta)$ is expressed as $g(k_{x'}, \theta)$.

[Equation 8]

$$g(k_{x'}, \theta) = \phi\,(k_{x'}\cos\theta, k_{x'}\sin\theta)$$

$$= \iint \phi\,(x'\cos\theta - y'\sin\theta, x'\sin\theta + y'\cos\theta, \alpha)exp(-ik_{x'}x')dx'dy'$$

$$= \int \left\{ \int \phi\,(x'\cos\theta - y'\sin\theta, x'\sin\theta + y'\cos\theta, \alpha)dy' \right\}exp(-ik_{x'}x')dx'$$

$$= \int f(x', \theta)exp(-ik_{x'}x')dx'$$

Meanwhile, $\phi$ (x, y, $\alpha$) can be represented by Equation 9, where $(k_x = k_x \cdot \cos\theta)$, $(k_y = k_x \cdot \sin\theta)$, and (x' = xcos$\theta$ + ysin$\theta$).

[Equation 9]

$$\phi\,(x, y, \alpha) = \iint \phi\,(k_x, k_y)exp(ik_x x + ik_y y)dk_x dk_y$$

$$= \iint \phi\,(k_{x'}\cos\theta, k_{x'}\sin\theta)exp(ik_{x'}(x\cos\theta + y\sin\theta))k_{x'}\,dk_{x'}d\theta$$

By substituting $\phi$ $(k_x \cos\theta, k_x \sin\theta)$ of Equation 8 into Equation 9, $\phi$ (x, y, $\alpha$) is represented by Equation 10.

[Equation 10]

$$\phi\,(x, y, \alpha) = \iint g(k_{x'}, \theta)exp(ik_{x'}(x\cos\theta + y\sin\theta))k_{x'}\,dk_{x'}d\theta$$

$$= \iint \left[ \int f(x', \theta)exp(-ik_{x'}x')dx' \right]exp(ik_{x'}(x\cos\theta + y\sin\theta))k_{x'}\,dk_{x'}d\theta$$

Consequently, by performing scanning on the measurement plane with the measuring part 21 so as to obtain measured values f(x', $\theta$) while changing the angle $\theta$ formed by the reference direction and the longitudinal direction of the measuring part 21 to a plurality of angles and then by Fourier transforming the measured values f(x', $\theta$) with respect to x' so as to obtain g(k_{x'}, $\theta$), it is possible to obtain $\phi$ (x, y, $\alpha$) using Equation 10 (hereinafter referred to as a "two-dimensional potential obtaining equation").

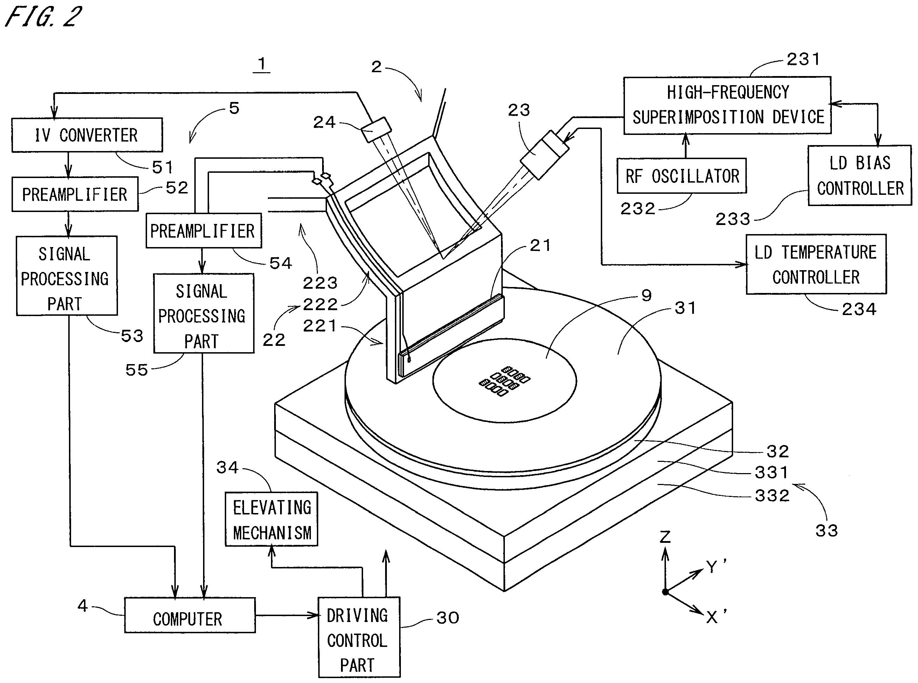

Next is a description of a magnetic field obtaining apparatus using the above-described two-dimensional potential obtaining method. Fig. 2 shows a configuration of a magnetic field obtaining apparatus 1. The magnetic field obtaining apparatus 1 includes a head part 2 that detects interaction between a sample and a sensor in order to control the distance between the sensor and the sample, a sample stage 31 that holds a sample 9 on a horizontal plane, a rotating mechanism 32 for rotating the sample stage 31 about an axis perpendicular to the horizontal plane, a horizontal moving mechanism 33 for moving the sample stage 31 together with the rotating mechanism 32 in the horizontal plane, an elevating mechanism 34 for moving the head part 2 (specifically, a later-described support part 22) in the vertical direction, a signal processing unit 5 for processing signals from the head part 2, and a computer 4 that controls the constituent elements of the magnetic field obtaining apparatus 1 and performs computations.

The head part 2 includes the measuring part 21 serving as a thin-film element and the support part 22 that holds the measuring part 21. The support part 22 has a support plate 221 whose normal line is horizontal, and the measuring part 21 is provided on a lower portion of the support plate 221 in the vertical direction (on the sample 9 side). The upper end of the support plate 221 is connected to one side of a sloping part 222 that is a substantially rectangular frame. The sloping part 222 is inclined with respect to the horizontal plane and the one side opposite to the support plate 221 is connected to a base part 223 that spreads in the horizontal direction.

The measuring part 21 is a sensor using a magnetoresistive effect (e.g., giant magnetoresistive (GMR) element) and is formed by laminating a plurality of rectangular films that are long in the horizontal direction on the support plate 221. Output signals from the measuring part 21 are input to the computer 4 via a preamplifier 54 and a signal processing part 55 of the signal processing unit 5. In the measuring part 21, a magnetic field that acts on the entire measuring part 21 is obtained by detection of a change in electrical resistance that occurs due to the magnetic field.

The head part 2 further includes a laser diode module (hereinafter referred to as an "LD module") 23 and a position sensitive photo-diode (hereinafter referred to as a "PSPD") 24. The LD module 23 is connected to a high-frequency superimposition device 231, and the high-frequency superimposition device 231 is connected to an RF oscillator 232 and an LD bias controller 233. The LD module 23 is also connected to an LD temperature controller 234, so that the temperature of the LD module 23 is adjusted to a constant temperature. In the magnetic field obtaining apparatus 1, under the control of the computer 4 serving as a control part, light is emitted from the LD module 23 serving as an emission part toward the vicinity of the end portion of the sloping part 222 on the support plate 221 side, and reflected light from the support part 22 is received by the PSPD 24 serving as a light receiving part. Signals from the PSPD 24 are output to the computer 4 via an I-V converter 51, a preamplifier 52, and a signal processing part 53 of the signal processing unit 5. As a result, the position of the support part 22 in the vertical direction is acquired with high precision. This prevents the support plate 221 from coming into contact with the sample 9.

The horizontal moving mechanism 33 includes first and second moving mechanisms 331 and 332 for horizontally moving the sample stage 31 in two directions perpendicular to each other. The directions in which the first and second moving mechanisms 331 and 332 move the sample stage 31 are fixed relative to the measuring part 21. The first moving mechanism 331 horizontally moves the sample stage 31 in a direction perpendicular to the longitudinal direction of the measuring part 21, and the second moving mechanism 332 horizontally moves the sample stage 31 in the longitudinal direction. The rotating mechanism 32, the horizontal moving mechanism 33, and the elevating mechanism 34 are connected to a driving control part 30.

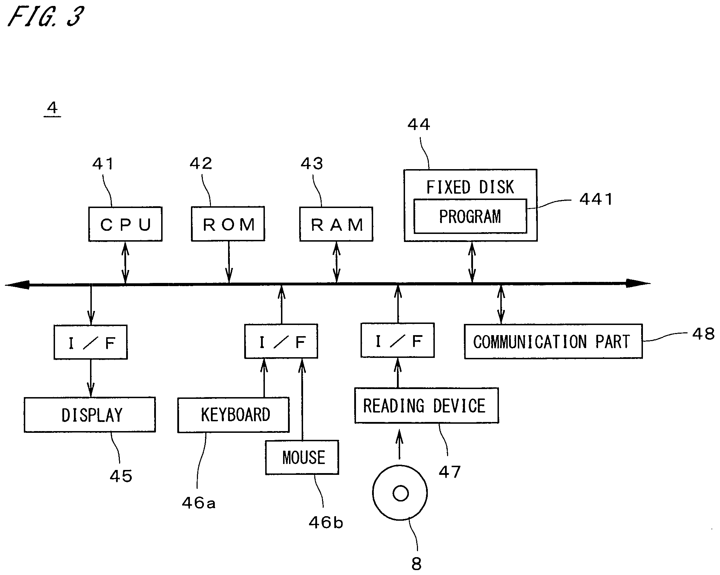

The computer 4 is, as shown in Fig. 3, a general computer system in which a CPU 41 that performs various types of computations, a ROM 42 that stores a basic program, and a RAM 43 that stores various types of information are connected to a bus line. To the bus line are further connected, via an interface (I/F) where appropriate, a fixed disk 44 that stores information, a display 45 that displays various types of information, a keyboard 46a and a mouse 46b that receive input from an operator, a reading device 47 that reads information from a computer-readable recording medium 8 such as an optical disk, a magnetic disk, or a magneto-optical disk, and a communication part 48 that transmits control signals to the head part 2 and the driving control part 30 and receives input of signals from the signal processing parts 53 and 55.

In the computer 4, a program 441 is read in advance from the recording medium 8 via the reading device 47 and stored in the fixed disk 44. The program 441 is then copied into the RAM 43, and the CPU 41 executes computational processing in accordance with the program in the RAM 43 (i.e., the computer 4 executes the program). This realizes a function of a later-described computing part.

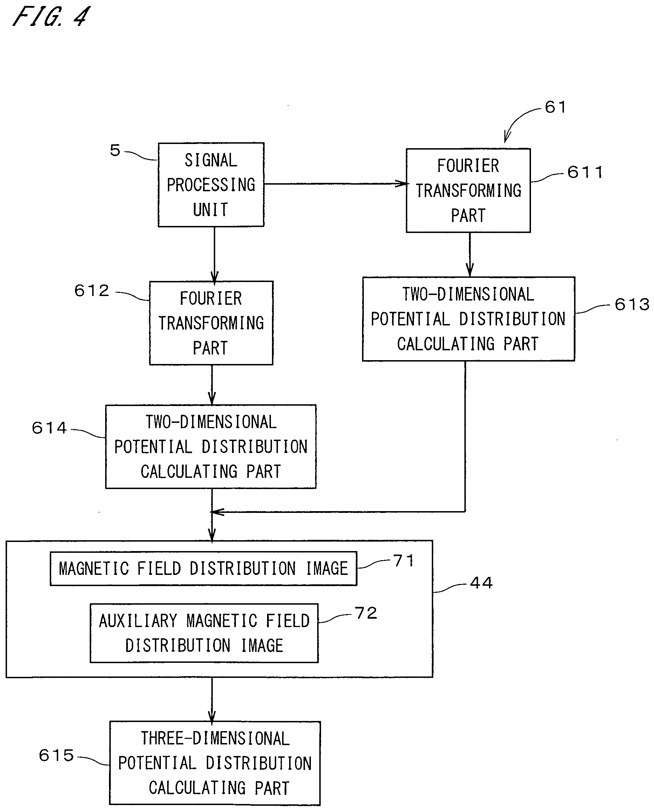

Fig. 4 is a block diagram showing, together with the signal processing unit 5, a functional configuration realized by the CPU 41, the ROM 42, the RAM 43, the fixed disk 44, and the like as a result of the CPU 41 operating in accordance with the program 441. Fig. 4 shows functions of a computing part 61 realized by the CPU 41 and the like, and the computing part 61 includes Fourier transforming parts 611 and 612, two-dimensional potential distribution calculating parts 613 and 614, and a three-dimensional potential distribution calculating part 615. Note that these functions may be realized by a dedicated electric circuit, or a dedicated electric circuit may be used in part. Alternatively, these functions may be realized by a plurality of computers.

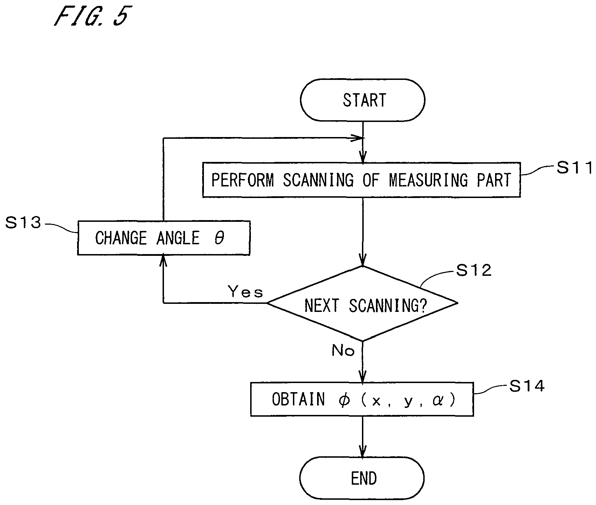

Fig. 5 is a flowchart of processing for obtaining a two-dimensional potential (distribution), performed by the magnetic field obtaining apparatus 1. In the following description, it is assumed that the XYZ rectangular coordinate system according to the above-described two-dimensional potential obtaining principle is set fixed relative to the sample 9, the X and Y directions are both horizontal, and the Z direction is vertical. The surface of the sample 9 is parallel to the XY plane, and the rotating mechanism 32 rotates the sample stage 31 about the Z axis. Accordingly, when the sample 9 is rotated together with the sample stage 31 by the rotating mechanism 32, the X and Y directions are also rotated together with the sample 9 on the horizontal plane. It is also assumed that the direction in which the sample stage 31 is moved by the first moving mechanism 331 (i.e., horizontal direction perpendicular to the longitudinal direction of the measuring part 21) is an X' direction, and the direction in which the sample stage 31 is moved by the second moving mechanism 332 (i.e., horizontal direction along the longitudinal direction of the measuring part 21) is an Y' direction.

In the measurement performed by the magnetic field obtaining apparatus 1 shown in Fig. 2, the measuring part 21 is disposed on an arbitrary measurement plane that is set outside the sample 9 and satisfies $z = \alpha$, and by the first moving mechanism 331 moving the sample stage 31 in the X' direction in Fig. 2, scanning is performed in which the measuring part 21 passes through over a measurement area of the sample 9 (step S11). As result, a magnetic field (specifically, Z-directional component) received by the measuring part 21 as a whole is obtained as a measured value at each position x' in the X direction that is the scanning direction.

When it is confirmed that the next scanning is to be performed (step S12), the rotating mechanism 32 serving as an angle changing part rotates the sample stage 31, whereby the X and Y directions fixed relative to the sample 9 are rotated together with the sample 9. As a result, the angle $\theta$ formed by the reference direction parallel to the Y direction on the measurement plane and the longitudinal direction of the measuring part 21 (Y' direction) is changed by a fixed small angle (e.g., an angle of 1 degree or more and 15 degrees or less (preferably, 10 degrees or less, and more preferably, 5 degrees or less)) (step S13). Then, the measuring part 21 is moved in the X' direction relative to the sample 9 on the measurement plane (i.e., scanning of the measuring part 21 is performed), and a magnetic field is obtained at each position x' (step S11). In the magnetic field obtaining apparatus 1, under the control of the computer 4, scanning of the measuring part 21 is repeated while the rotating mechanism 32 changes the angle $\theta$ to a plurality of angles, as a result of which measured values $f(x', \theta)$ using x' and $\theta$ as parameters are acquired (steps S12, S13, and S11). The plurality of angles $\theta$ in the present embodiment are equidistant angles in a range of greater than or equal to 0° and less than 180°.

When the measured values $f(x', \theta)$ have been obtained by repetitions of the scanning with the measuring part 21 (step S12), the Fourier transforming part 611 Fourier transforms the measured values $f(x', \theta)$ with respect to x' so as to obtain $g(k_{x'}, \theta)$. Then, the two-dimensional potential distribution calculating part 613 substitutes $g(k_{x'}, \theta)$ into the two-dimensional potential obtaining equation (Equation 10) so as to obtain $\phi(x, y, \alpha)$ that indicates a two-dimensional potential on the measurement plane (step S14).

Incidentally, when the two-dimensional distribution of a magnetic field is obtained using a superconducting quantum interference device or a magnetoresistive sensor, there is a technical limit to miniaturization of these devices, and thus there is a certain limit to improvement in the resolution of measurement.

In contrast, in the magnetic field obtaining apparatus 1 in Fig. 2 serving as a potential obtaining apparatus, the measuring part 21 that is sufficiently longer than the width of the measurement target area is used, and scanning in the direction perpendicular to the longitudinal direction of the measuring part 21 is repeated on the measurement plane while changing the angle $\theta$ formed by the reference direction on the measurement plane and the longitudinal direction of the measuring part 21 to a plurality of angles. Then, the measured values $f(x', \theta)$ obtained by repetitions of the scanning are used to obtain $\phi(x, y, \alpha)$ that indicates a two-dimensional potential on the measurement plane by the two-dimensional potential obtaining equation. As a result, by using the measuring part 21 that is sufficiently larger than the width of the measurement target area, it is possible to perform two-dimensional potential measurement with a high resolution (e.g., nanoscale resolution) in both the X and Y directions. In this case, the resolution is determined by the film thickness of the thin-film element. Since it is easy to control the thickness of a thin film, in principle the resolution can be improved to the atomic or molecular scale. Note that a superconducting quantum interference device having a long measurement range in the horizontal direction may be used as the measuring part 21 (the same applies to apparatuses described below).

Next is a description of a technique for obtaining a three-dimensional potential (distribution) using the above-described two-dimensional potential obtaining method. A three-dimensional potential is obtained using a technique similar to that of WO/2008/123432 (Document 2). With the technique described below, $\phi(x, y, z)$ indicating a three-dimensional potential that satisfies the Laplace equation is obtained.

First, the principle of obtaining a three-dimensional potential will be described. The three-dimensional potential $\phi(x, y, z)$ that satisfies the Laplace equation is represented by Equation 11 using Laplacian $\Delta$.

[Equation 11]

$$\Delta \phi (x,y,z) = 0$$

The general solution of this equation can be represented by Equation 12 as the sum of a term that exponentially decreases in the Z direction in the XYZ rectangular coordinate system and a term that exponentially increases in the Z direction in the system.

[Equation 12]

$$\phi(x,y,z) = \iint exp(ik_x x + ik_y y)\{a(k_x,k_y)exp(z\sqrt{k_x^2+k_y^2}) + b(k_x,k_y)exp(-z\sqrt{k_x^2+k_y^2})\}dk_x dk_y$$

In Equation 12, $k_x$ and $k_y$ are respectively wavenumbers in the X direction and the Y direction, and $a(k_x, k_y)$ and $b(k_x, k_y)$ are functions represented by $k_x$ and $k_y$. Both sides of Equation 12 are further differentiated once with respect to z, the result of which is represented by Equation 13.

[Equation 13]

$$\phi_z(x,y,z) = \iint exp(ik_x x + ik_y y)\sqrt{k_x^2+k_y^2}\{a(k_x,k_y)exp(z\sqrt{k_x^2+k_y^2}) - b(k_x,k_y)exp(-z\sqrt{k_x^2+k_y^2})\}dk_x dk_y$$

Here, $\phi$(x, y, z) on a plane that is parallel to the XY plane and satisfies z = 0, namely $\phi$(x, y, 0), is represented by Equation 14.

[Equation 14]

$$\phi(x,y,0) = \iint exp(ik_x x + ik_y y)\{a(k_x,k_y)+b(k_x,k_y)\}dk_x dk_y$$

Similarly, z = 0 is substituted into Equation 13 and thereby $\phi_z$(x, y, 0) is represented by Equation 15.

[Equation 15]

$$\phi_z(x,y,0) = \iint exp(ik_x x + ik_y y)\sqrt{k_x^2+k_y^2}\{a(k_x,k_y)-b(k_x,k_y)\}dk_x dk_y$$

Accordingly, $\phi$($k_x$, $k_y$)$|_{z=0}$ and $\phi_z$($k_x$, $k_y$)$|_{z=0}$ (hereinafter simply expressed as $\phi$($k_x$, $k_y$), $\phi_z$($k_x$, $k_y$)) obtained by Fourier transforming $\phi$(x, y, 0) and $\phi_z$(x, y, 0) are respectively represented by Equations 16 and 17.

[Equation 16]

$$\phi(k_x,k_y) = a(k_x,k_y)+b(k_x,k_y)$$

[Equation 17]

$$\phi_z(k_x,k_y) = \sqrt{k_x{}^2+k_y{}^2}\{a(k_x,k_y)-b(k_x,k_y)\}$$

From Equations 16 and 17, it is possible to obtain a($k_x$, $k_y$) and b($k_x$, $k_y$) that are respectively represented by Equations 18 and 19.

[Equation 18]

$$a(k_x,k_y) = \frac{1}{2}\left[\phi(k_x,k_y)+\frac{\phi_z(k_x,k_y)}{\sqrt{k_x{}^2+k_y{}^2}}\right]$$

[Equation 19]

$$b(k_x,k_y) = \frac{1}{2}\left[\phi(k_x,k_y)-\frac{\phi_z(k_x,k_y)}{\sqrt{k_x{}^2+k_y{}^2}}\right]$$

Here, $\phi$ (x, y, z) is represented by Equation 20 by substituting a($k_x$, $k_y$) and b($k_x$, $k_y$) of Equations 18 and 19 into Equation 12.

[Equation 20]

$$\phi(x,y,z)$$
$$= \iint exp(ik_x x+ik_y y)\{\frac{1}{2}\left[\phi(k_x,k_y)+\frac{\phi_z(k_x,k_y)}{\sqrt{k_x{}^2+k_y{}^2}}\right]exp(z\sqrt{k_x{}^2+k_y{}^2})$$
$$+\frac{1}{2}\left[\phi(k_x,k_y)-\frac{\phi_z(k_x,k_y)}{\sqrt{k_x{}^2+k_y{}^2}}\right]exp(-z\sqrt{k_x{}^2+k_y{}^2})\}dk_xdk_y$$

Due to the above, in the case where $\phi$(x, y, 0) serving as the Dirichlet boundary condition and $\phi_z$(x, y, 0) serving as the Neumann boundary condition can be obtained by measurement performed on a measurement plane that is set outside the object and satisfies z = 0, they are Fourier transformed so as to derive a Fourier transformed function of $\phi$(x, y, z) with respect to x and y as shown in Equation 20 and it is inverse-Fourier transformed, whereby it is possible to obtain $\phi$(x, y, z) and to precisely derive a three-dimensional potential.

Meanwhile, a($k_x$, $k_y$) and b($k_x$, $k_y$) can also be obtained by performing processing compliant with that for deriving Equation 20 on functions that are obtained by differentiating Equation 12 odd times and even times, respectively, with respect to z, and it is possible to derive an equation that corresponds to Equation 20 in which $\phi$ (x, y, z) are differentiated once or more times. It is assumed here that q and p are integers greater than or equal to 0, q being odd and p being even (i.e., q = 1, p = 0 (mod 2)). Also, $H_z^{(q)}$(x, y, z) and $H_z^{(p)}$(x, y, z) represent functions that are obtained by differentiating a field function H(x, y, z) q times and p times, respectively, with respect to z, the field function H (x, y, z) indicating a field that satisfies the Laplace equation. Assuming that $h_z^{(q)}$($k_x$, $k_y$) represents a Fourier transformed function of $H_z^{(q)}$(x, y, 0) (i.e., Equation 21) with respect to x and y, and $h_z^{(p)}$($k_x$, $k_y$) represents a Fourier transformed function of $H_z^{(p)}$(x, y, 0) with respect to x and y, $H_z^{(q)}$(x, y, z) and $H_z^{(p)}$(x, y, z) are respectively represented by Equations 22 and 23.

[Equation 21]

$$H_z^{(q)}(x,y,0) = \left.\frac{\partial^q H_z(x,y,z)}{\partial z^q}\right|_{z=0}$$

[Equation 22]

$$H_z^{(q)}(x,y,z) =$$

$$\iint exp(ik_xx+ik_yy)\left\{\frac{1}{2}\left(h_z^{(q)}(k_x,k_y) + h_z^{(p)}(k_x,k_y)\left(k_x^2+k_y^2\right)^{\frac{q-p}{2}}\right)exp(z\sqrt{k_x^2+k_y^2})\right.$$

$$\left.+\frac{1}{2}\left(h_z^{(q)}(k_x,k_y) - h_z^{(p)}(k_x,k_y)\left(k_x^2+k_y^2\right)^{\frac{q-p}{2}}\right)exp(-z\sqrt{k_x^2+k_y^2})\right\}dk_xdk_y$$

[Equation 23]

$$H_z^{(p)}(x,y,z) =$$

$$\iint exp(ik_xx+ik_yy)\left\{\frac{1}{2}\left(h_z^{(p)}(k_x,k_y) + h_z^{(q)}(k_x,k_y)\left(k_x^2+k_y^2\right)^{\frac{p-q}{2}}\right)exp(z\sqrt{k_x^2+k_y^2})\right.$$

$$\left.+\frac{1}{2}\left(h_z^{(p)}(k_x,k_y) - h_z^{(q)}(k_x,k_y)\left(k_x^2+k_y^2\right)^{\frac{p-q}{2}}\right)exp(-z\sqrt{k_x^2+k_y^2})\right\}dk_xdk_y$$

Due to the above, in the case where $H_z^{(q)}(x, y, 0)$ and $H_z^{(p)}(x, y, 0)$ can be obtained by measurement, they are Fourier transformed so as to obtain $h^{(q)}(k_x, k_y)$ and $h^{(p)}(k_x, k_y)$ and derive a Fourier transformed function of $H_z^{(q)}(x, y, z)$ or $H_z^{(p)}(x, y, z)$ from $h^{(q)}(k_x, k_y)$ and $h^{(p)}(k_x, k_y)$ using Equation 22 or 23, and it is inverse-Fourier transformed, whereby it is possible to obtain $H_z^{(q)}(x, y, z)$ or $H_z^{(p)}(x, y, z)$.

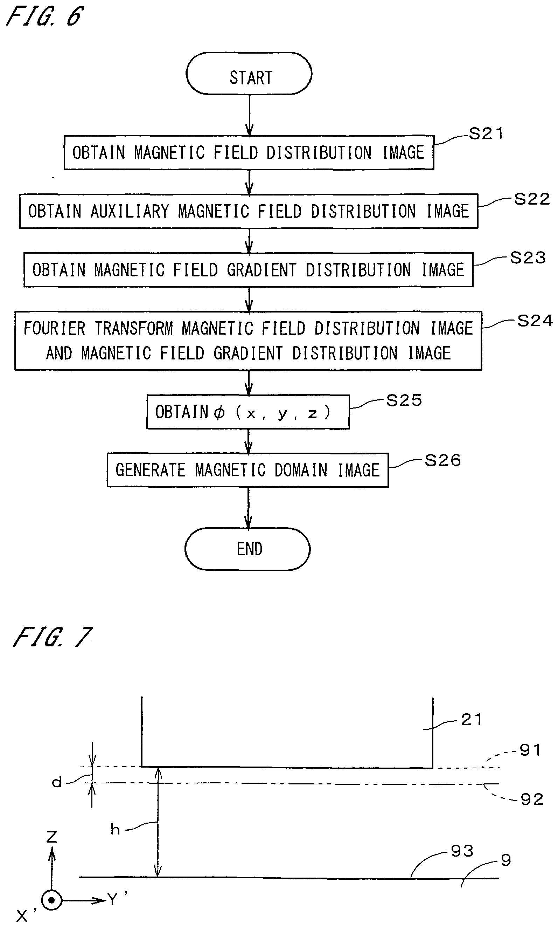

The magnetic field obtaining apparatus 1 in Fig. 2 is also capable of obtaining a three-dimensional potential using the above-described three-dimensional potential obtaining method. Fig. 6 is a flowchart of processing for obtaining a three-dimensional potential, performed by the magnetic field obtaining apparatus 1.

In the three-dimensional potential obtaining processing, the end face of the measuring part 21 on the (-Z) side is disposed on a measurement plane 91 that satisfies z = 0 as indicated by the broken line in Fig. 7, and steps S11 to S14 in Fig. 5 are performed so as to obtain $\phi$(x, y, 0). In the present embodiment, the two-dimensional potential distribution calculating part 613 converts a value of $\phi$(x, y, 0) (value indicating the magnitude of a magnetic field) at each position on the measurement plane 91 into a pixel value, and a two-dimensional distribution of the magnetic field on the measurement plane 91 is stored as a magnetic field distribution image 71 (to be precise, image data) in the fixed disk 44 (see Fig. 4) (Fig. 6: step S21). In actuality, the processing of step S21 has already been completed by execution of the previously-described processing in Fig. 5.

Then, the head part 2 is moved down by a small distance d (d > 0) in the Z direction by the elevating mechanism 34 shown in Fig. 2, so that the distance between the measuring part 21 and the sample 9 is changed by the small distance d as indicated by the dashed double-dotted line in Fig. 7. That is, a plane 92 that is away from the measurement plane 91 fixed relative to the sample 9 by the small distance d in the (-Z) direction is taken as a new measurement plane. Then, steps S11 to S14 in Fig. 5 are performed in a similar manner to the processing of step S21, as a result of which a magnetic field distribution on the measurement plane 92 (i.e., $\phi$ (x, y, -d)) is obtained as an auxiliary magnetic field distribution image 72 (step S22). Note that in the processing of step S22, the measured values f(x', θ) are output from the signal processing unit 5 to the Fourier transforming part 612 in Fig. 4, and the two-dimensional potential distribution calculating part 614 generates the auxiliary magnetic field distribution image 72. Of course, both of the magnetic field distribution image 71 and the auxiliary magnetic field distribution image 72 may be generated by a single Fourier transforming part and a single two-dimensional potential distribution calculating part.

When the magnetic field distribution image 71 and the auxiliary magnetic field distribution image 72 (they may be respectively taken as a potential distribution image and an auxiliary potential distribution image) are prepared, the three-dimensional potential distribution calculating part 615 obtains a difference image between these two images and divides the difference image by the small distance d so as to generate a differential image. The differential image is an image that substantially indicates a Z-directional differentiation of the magnetic field on the measurement plane 91, i.e., the gradient of the magnetic field, and is stored as a magnetic field gradient distribution image (which can also be taken as a potential gradient distribution image) (step S23).

As described previously, the magnetic field distribution image 71 is expressed as $\phi$(x, y, 0). Since the gradient of the magnetic field is obtained by differentiating the magnetic field with respect to z, the magnetic field gradient distribution image is an image that indicates $\phi_z^{(1)}$(x, y, 0) (hereinafter expressed as $\phi_z$(x, y, 0)). If the magnetic field distribution image 71 is a first image, the auxiliary magnetic field distribution image 72 is an intermediate image, and the magnetic field gradient distribution image is a second image, steps S21 to S23 are steps of obtaining the two-dimensional first and intermediate images that indicate the magnetic field distribution and then obtaining the second image that indicates the gradient of the magnetic field from the first and intermediate images.

Then, the three-dimensional potential distribution calculating part 615 Fourier transforms the magnetic field distribution image 71 expressed as $\phi$ (x, y, 0) and the magnetic field gradient distribution image expressed as $\phi_z$(x, y, 0) with respect to x and y so as to obtain $\phi(k_x, k_y)$ and $\phi_z(k_x, k_y)$ (where $k_x$ and $k_y$ are respectively wavenumbers in the X direction and the Y direction) (step S24). Specifically, a two-dimensional discrete Fourier transform is performed as a Fourier transform, and for example, a technique in which both of the images are multiplied by the n-th power (n is 0 or greater) of a sine function in the range of 0 to π as a window function is employed for Fourier transforms.

When $\phi(k_x, k_y)$ and $\phi_z(k_x, k_y)$ have been obtained, $\phi$(x, y, z) is obtained by the equation expressed as Equation 20 (hereinafter referred to as a "three-dimensional potential obtaining equation") using $\phi(k_x, k_y)$ and $\phi_z(k_x, k_y)$ (step S25). Note that when $\phi(k_x, k_y)$ and $\phi_z(k_x, k_y)$ are substituted into the three-dimensional potential obtaining equation and an inverse-Fourier transform is performed with respect to $k_x$ and $k_y$, a window function similar to that used for Fourier transforms is used. By obtaining $\phi$ (x, y, z), it is possible to precisely derive the three-dimensional distribution of the z component of the magnetic field.

Next, when, as shown in Fig. 7, the distance between a measurement target material surface 93 of the sample 9 that is embedded in a medium, and the measurement plane 91 that satisfies z = 0 is h (h > 0), the three-dimensional potential distribution calculating part 615 substitutes a value (-h) that indicates the position of the measurement target material surface 93 that is embedded in the medium (or value that indicates a position close to the measurement target material surface 93 that is embedded in the medium) into z of $\phi$ (x, y, z) so as to obtain a magnetic field distribution on the measurement target material surface 93 that is embedded in the medium (step S26). Since the magnetic domain structure on the measurement target material surface 93 that is embedded in the medium corresponds to the magnetic field distribution, the magnetic field obtaining apparatus 1 stores an image indicating $\phi$ (x, y, -h) as a magnetic domain image that indicates the magnetic domain structure in the fixed disk 44. Through the above-described operations, even if the sensor cannot be brought close to the measurement target material surface 93 that is embedded in the medium due to the influence of a substance such as a protective film that is present on the magnetic material, it is possible to obtain a magnetic field distribution image in the vicinity of the measurement target material surface 93 that is embedded in the medium. It is thus possible with the magnetic field obtaining apparatus 1 to realize a magnetic field microscope having a high spatial resolution of 10 nm or less (or 2 to 3 nm or less depending on the design).

As described above, in the magnetic field obtaining apparatus 1, the magnetic field distribution image 71 and the auxiliary magnetic field distribution image 72 on two different measurement planes that are away from each other by a small distance in the Z direction are obtained using similar techniques, and a difference image between these images is divided by the small distance so as to obtain a differential image as a magnetic field gradient distribution image. Then, $\phi$ (x, y, 0) that indicates the magnetic field distribution image 71 and $\phi_z$(x, y, 0) that indicates the magnetic field gradient distribution image are respectively Fourier transformed so as to obtain $\phi(k_x, k_y)$ and $\phi_z(k_x, k_y)$, and $\phi$(x, y, z) is obtained from the three-dimensional potential obtaining equation using $\phi(k_x, k_y)$ and $\phi_z(k_x, k_y)$. As a result, a three-dimensional potential can be obtained with high precision. Moreover, by the computing part 61 substituting a value that indicates either the position of the measurement target material surface 93 of the sample 9 that is embedded in the medium or a position close to the measurement target material surface 93 that is embedded in the medium into z of $\phi$ (x, y, z), it is possible to obtain a magnetic domain image that indicates a magnetic domain structure on the measurement target material surface 93 that is embedded in the medium. The magnetic field obtaining apparatus 1 can thus realize a magnetic field microscope having a high spatial resolution.

Incidentally, other apparatuses (e.g., a scanning tunneling microscope and a scanning electron microscope) that are used to observe the surface of a magnetic material are able to observe only an extremely clean surface of a magnetic material. In contrast, the magnetic field obtaining apparatus 1 are capable of measuring magnetic domains embedded in a non-magnetic substance even if the surface of the sample 9 is not clean, and is thus applicable as a practical evaluation apparatus or an inspection apparatus used on the manufacturing line. It is also conceivable to use the magnetic field obtaining apparatus 1 as a detector used in a hard disk driving apparatus.

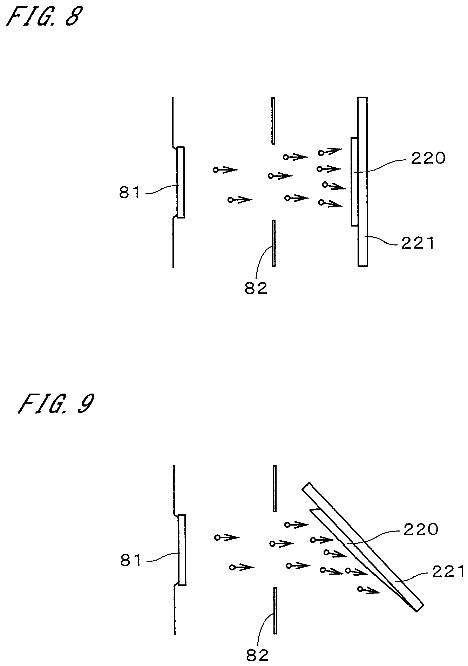

Next is a description of a preferable technique for forming a thin film in connection with the manufacture of the measuring part 21. Fig. 8 shows a condition in which a thin film of a magnetic material is formed on a rectangular substrate (hereinafter denoted by the same reference numeral 221) that will serve as the support plate 221 of the support part 22. As described previously, the measuring part 21 is a multilayer film of a magnetic material (material including cobalt (Co), nickel (Ni), iron (Fe) or the like). For example, when a thin film of a magnetic material is formed, the substrate 221 is disposed in parallel with a plate-like evaporation source 81 at a position opposed to the evaporation source 81 for the magnetic material, and a mask 82 having an opening is disposed between the evaporation source 81 and the substrate 221 (In Fig. 8, parallel oblique lines that indicate a cross section are not shown, and the same applies to Fig. 9). Then, a thin film 220 of the magnetic material is formed on an area of the substrate 221 that corresponds to the shape of the opening of the mask 82 by vacuum deposition. In this way, a thin film element that spreads along the main surface of the substrate 221 (i.e., the measuring part 21 that spreads in the Y' and Z directions in Fig. 2) is formed by deposition of a substance for forming a thin film.

Next, a more preferable technique for forming a thin film will be described. Fig. 9 shows a condition in which a thin film of a magnetic material is formed on a substrate 221. With the thin-film forming technique shown in Fig. 9, the substrate 221 is disposed so as to face a plate-like evaporation source 81 and to be inclined with respect to the evaporation source 81. To be more specific, the lower side in Fig. 9 corresponds to the (-Z) side in the magnetic field obtaining apparatus 1 of Fig. 2, and the rectangular substrate 221 is inclined such that the lower portion of the substrate 221 is away from the evaporation source 81. Then, evaporation is performed in this state, as a result of which, as shown in Fig. 9, a thin film 220 is formed in the lower portion of the substrate 221 so as to have a film thickness that gradually decreases toward the lower side. In other words, a measuring part is formed such that the film thickness of the thin film 220 on the lower side of the substrate 221 (i.e., the sample 9 side in the magnetic field obtaining apparatus 1) is smaller than that of the other portion. In the measuring part, since the resolution in the X' direction serving as the film thickness direction is affected by the film thickness of the lower end portion of the thin film 220 (in actuality, the film thickness of the multilayer film), the measuring part that is formed using the technique shown in Fig. 9 such that the film thickness gradually decreases toward the object is capable of obtaining a measured value having a high resolution in the X' direction as compared with the measuring part formed using the technique shown in Fig. 8. Such a thin film element whose film thickness gradually decreases toward the object may be formed using another technique.

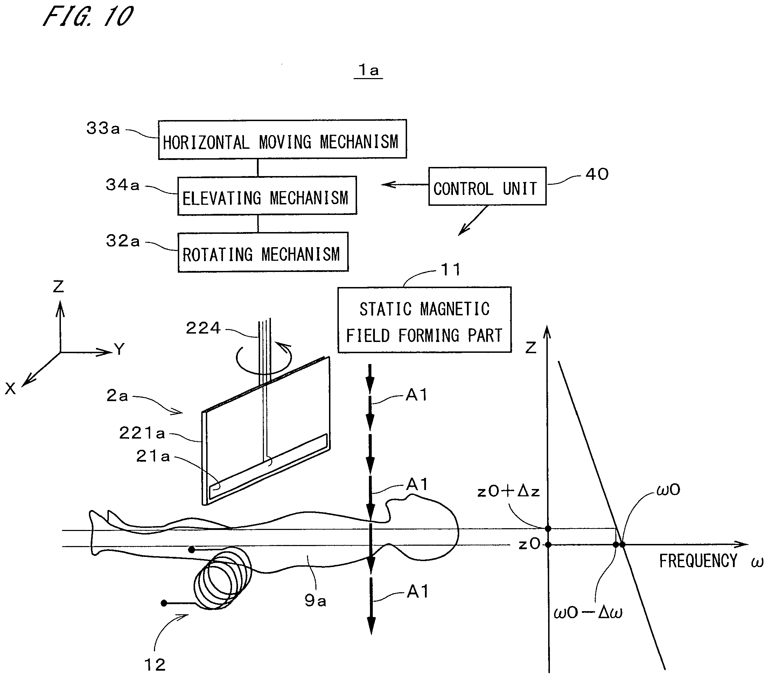

Fig. 10 is a diagram illustrating an inspection apparatus 1a that employs the above-described two-dimensional potential obtaining method. The inspection apparatus 1a is an MRI apparatus that obtains an image through magnetic resonance imaging (MRI). The left side in Fig. 10 shows a configuration of the inspection apparatus 1a, and the right side shows the relationship between the Z-directional position of a cross section of an object 9a to be inspected (which is a cross section parallel to the XY plane in Fig. 10 and hereinafter referred to as an "inspection target surface") and the frequency $\omega$ of a rotating magnetic field that is applied to the object 9a by a transmission coil 12 described later.

The inspection apparatus 1a includes a static magnetic field forming part 11 that forms a gradient magnetic field in the Z direction with respect to the object 9a that is a human body lying in the Y direction in Fig. 10, the transmission coil 12 that applies a rotating magnetic field to the object 9a, a head part 2a disposed on the (+Z) side of the object 9a, a rotating mechanism 32a for rotating the head part 2a around an axis parallel to the Z direction, an elevating mechanism 34a for elevating the head part 2a in the Z direction together with the rotating mechanism 32a, a horizontal moving mechanism 33a for moving the head part 2a in the X and Y directions together with the rotating mechanism 32a and the elevating mechanism 34a, and a control unit 40 that is connected to the constituent elements of the inspection apparatus 1a. In Fig. 10, the lengths of a plurality of arrows indicated by reference character A1 gradually increase in the (-Z) direction from the (+Z) side, thereby showing, in an abstract manner, a state in which the intensity of the static magnetic field formed by the static magnetic field forming part 11 gradually increases in the (-Z) direction.

The head part 2a includes a measuring part 21a that is sufficiently (e.g., two or more times) longer than the width of the object 9a in the X direction, and a support plate 221a to which the measuring part 21a is fixed. The support plate 221a is attached to the rotating mechanism 32a via a support bar 224.

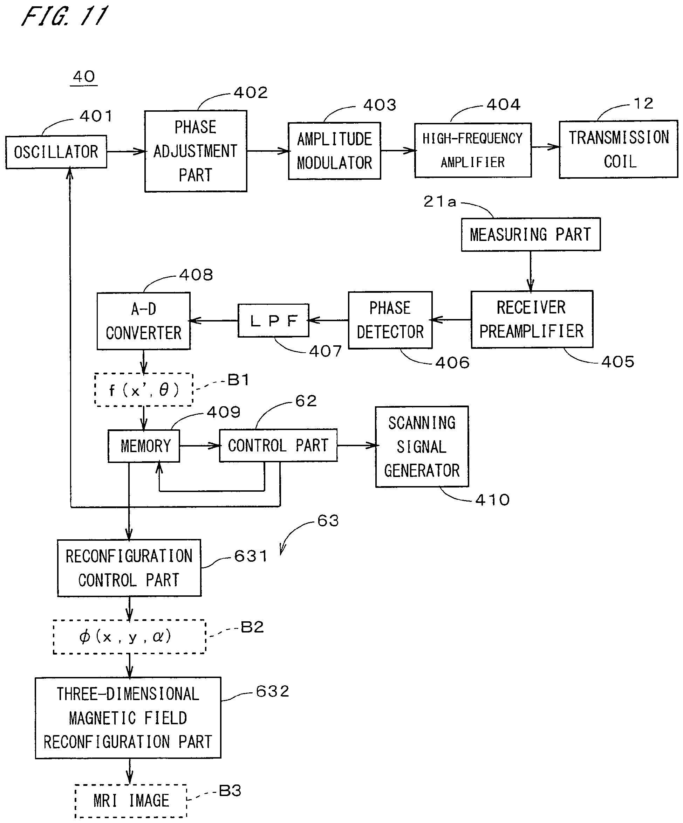

Fig. 11 shows a functional configuration of the control unit 40 together with the measuring part 21a and the transmission coil 12. A control part 62 and a computing part 63 in Fig. 11 are functions realized by a computer included in the control unit 40.

The control part 62 is connected to a scanning signal generator 410, and the head part 2a is moved by the horizontal moving mechanism 33a so as to perform scanning based on a signal from the scanning signal generator 410.

The control part 62 is also connected to the transmission coil 12 via an oscillator 401, a phase adjustment part 402, an amplitude modulator 403, and a high-frequency amplifier 404, and a rotating magnetic field of frequency according to control of the control part 62 is applied from the transmission coil 12 to the object 9a. The measuring part 21a is connected to a receiver preamplifier 405, and a signal from the measuring part 21a is amplified by the receiver preamplifier 405 and is output to a phase detector 406, an LPF 407, and an A-D converter 408 in the order. Then, output signals from the A-D converter 408 are stored as measured values f(x', $\theta$) in a memory 409. Note that in Fig. 11, the content of each signal output from the A-D converter 408 is indicated by being enclosed in the broken-line rectangle denoted by reference character B1 (the same applies to rectangles B2 and B3).

A reconfiguration control part 631 of the computing part 63 in Fig. 11 has a function similar to those of the Fourier transforming part 611 and the two-dimensional potential distribution calculating part 613 in Fig. 4 and obtains $\phi$(x, y, $\alpha$) on a measurement plane on which the measuring part 21a is disposed and that satisfies z = $\alpha$, based on the measured values f(x', $\theta$) stored in the memory 409. A three-dimensional magnetic field reconfiguration part 632 has a function similar to that of the three-dimensional potential distribution calculating part 615 in Fig. 4, and obtains $\phi$ (x, y, z) based on $\phi$(x, y, $\alpha$), as well as an MRI image described later.

When a plane of the object 9a that satisfies z = z0 is taken as an inspection target surface, as shown in the right side in Fig. 10, a rotating magnetic field with a frequency $\omega$0 (also called an RF pulse (90-degree pulse)) is applied to the object 9a so as to induce nuclear magnetic resonance (NMR) on the inspection target surface of the object 9a. Furthermore, as will be described later, an MRI image on the inspection target surface is obtained by the measuring part 21a performing scanning in synchronization with the application of a rotating magnetic field. The following is a description of the procedure of inspection operations performed by the inspection apparatus 1a in accordance with Fig. 6.

In the inspection apparatus 1a, the end face of the measuring part 21a on the (-Z) side is disposed on a measurement plane that satisfies z = 0, and the processing of steps S11 to S13 in Fig. 5 is performed. At this time, during each scan performed by the measuring part 21a in step S11, the measuring part 21a is stopped at each position x' in the scanning direction (i.e., X' direction). Then, a rotating magnetic field with the frequency $\omega$0 is applied from the transmission coil 12 to the object 9a, which induces nuclear magnetic resonance on the inspection target surface. Then, a change in the measured value obtained by the measuring part 21a is obtained for a predetermined amount of time after driving of the transmission coil 12 has stopped (i.e., after the application of the rotating magnetic field has stopped). Driving the transmission coil 12 and obtaining a change in the measured value after driving of the transmission coil 12 has stopped is performed at all positions x' in the X' direction during the scan. This completes a single scan by the measuring part 21a. By performing the above-described operations during every scan at every angle $\theta$, a magnetic field distribution image expressed as $\phi$ (x, y, 0) is obtained by the reconfiguration control part 631 (Fig. 5: step S14, Fig. 6: step S21). In actuality, $\phi$ (x, y, 0, t) that includes elapsed time t that has elapsed after the driving of the transmission coil 12 had stopped, as a parameter, is obtained as a function that indicates a magnetic field distribution image for each elapsed time t.

When $\phi$ (x, y, 0, t) has been obtained, the head part 2a is moved by a small distance d in the Z direction by the elevating mechanism 34a. Thereafter, processing similar to the above-described processing of step S21 is performed so as to obtain $\phi$ (x, y, -d, t) as a function that indicates an auxiliary magnetic field distribution image for each elapsed time t (step S22). Then, a difference between $\phi$ (x, y, 0, t) and $\phi$ (x, y, -d, t) is divided by the small distance d so as to obtain $\phi_z$(x, y, 0, t) (i.e., magnetic field gradient distribution image obtained by dividing a difference image between the magnetic field distribution image and the auxiliary magnetic field distribution image for each elapsed time t by the small distance d) (step S23). Then, $\phi$ (x, y, 0, t) and $\phi_z$(x, y, 0, t) are respectively Fourier transformed and used to obtain $\phi$ (x, y, z, t) by the three-dimensional potential obtaining equation (steps S24 and S25).

Here, if the position in the Z direction on the inspection target surface is z0, $\phi$ (x, y, z, t) indicates $\phi$ (x, y, z) for each elapsed time t after driving of the transmission coil 12 has stopped. Accordingly, by substituting z0 into z of $\phi$ (x, y, z, t) obtained for the inspection target surface, $\phi$ (x, y, z0, t) that indicates a temporal change in the magnetic field at each position (x, y) on the inspection target surface after the application of the rotating magnetic field has stopped is obtained as a function that indicates an excited-state relaxation phenomenon. Then, through predetermined computation, an image that indicates a difference in the relaxation phenomenon at each position (x, y) on the inspection target surface is obtained as an MRI image (step S26).

The above-described processing of steps S21 to S26 is repeated while using each of a plurality of planes located at a plurality of positions in the Z direction as the inspection target surface. In this case, for example, when a plane that satisfies z = (z0 + $\Delta$z) is used as the inspection target surface, a rotating magnetic field with a frequency ($\phi$0 - $\Delta\omega$) is applied to the object 9a. If y is the gyromagnetic ratio and Gz is the gradient of a gradient magnetic field, $\Delta\omega$ is expressed as ($\gamma$•Gz•$\Delta$z) (i.e., ($\Delta\omega$ = $\gamma$•Gz•$\Delta$z)). As a result, MRI images on a plurality of planes located at a plurality of positions in the Z direction are obtained.

As described above, in the inspection apparatus 1a in Fig. 10, the static magnetic field forming part 11 and the transmission coil 12 operate cooperatively and thereby nuclear magnetic resonance is sequentially induced inside the object 9a on a plurality of planes located at a plurality of positions in the Z direction. Then, when nuclear magnetic resonance has been induced on each plane included in the plurality of planes, the control part 62 causes the computing part 63 to obtain $\phi$ (x, y, z) for each elapsed time t and further causes the computing part 63 to substitute a value that indicates the position of the plane into z of $\phi$ (x, y, z). As a result, a relaxation phenomenon is obtained at each position (x, y) on the plane serving as the inspection target surface. This makes it possible to obtain a high-precision MRI image on the inspection target surface. In this way, the inspection apparatus 1a enables high-precision inspection using nuclear magnetic resonance. The inspection apparatus 1a in Fig. 10 is also capable of reducing senses of oppression and closeness that a subject may feel toward a general tunnel-type MRI apparatus. Since, unlike a normal MRI, the inspection apparatus 1a does not need to form a steep gradient of the magnetic field in the X and Y directions, the spatial resolution in the X and Y directions is determined by the film thickness of the thin-film magnetic field sensor, which enables high-resolution inspection. This makes it possible to realize downsizing of the apparatus and enables clinical application such as real-time high-resolution inspection during a surgical operation.

Although in the above-described embodiments, the measuring part 21 or 21a obtains a measured value based on a potential derived by differentiating a magnetic potential once with respect to the Z direction, the measuring part may obtain a measured value based on a potential that is derived by differentiating a magnetic potential twice with respect to the Z direction. In the following description, $\phi$ (x, y, z) is $\Phi_z^{(2)}$(x, y, z) (hereinafter expressed as $\Phi_{zz}$(x, y, z)) that is obtained by differentiating $\Phi$(x, y, z) twice with respect to z.

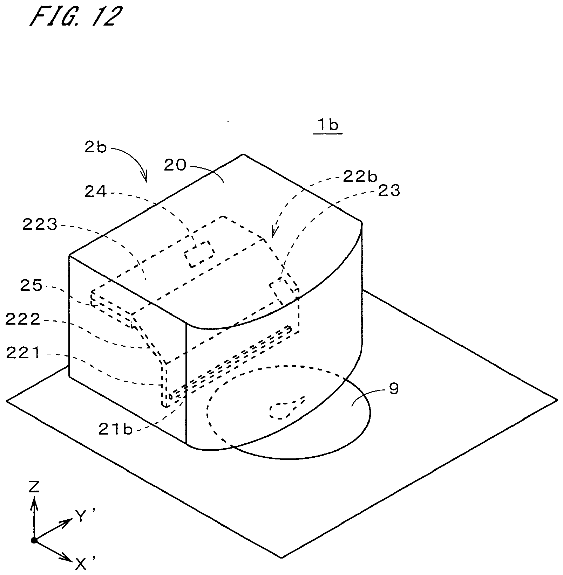

Fig. 12 shows part of a magnetic field obtaining apparatus 1b according to a second embodiment of the present invention. The magnetic field obtaining apparatus 1b differs from the magnetic field obtaining apparatus 1 in Fig. 2 in the configuration of a head part 2b. The other constituent elements are similar to those in Fig. 2 and thus not shown in Fig. 12.

In the head part 2b, a thin film that is formed of a magnetic material and is magnetized is provided as a measuring part 21b on a support plate 221 of a support part 22b, and a magnetic force acts between the entire measuring part 21b that is long in the Y' direction and a sample 9. The support plate 221 is connected to a base part 223 via a sloping part 222, and the base part 223 is provided with a vibrating part 25 that causes a cantilevered support part 22b (hereinafter referred to as a "cantilever 22b") to vibrate. The head part 2b is provided with an LD module 23 and a PSPD 24 that are similar to those of the head part 2 in Fig. 2, and the measuring part 21b, the cantilever 22b, the vibrating part 25, the LD module 23, and the PSPD 24 are housed in a closed container 20. The inside of the container 20 is decompressed so as to improve the Q-value of the cantilever 22b. The side faces and upper face ((+Z)-side face) of the container 20 are made of a predetermined magnetic shielding material and enable a considerable reduction in the influence of noise during measurement in connection with the improvement in the Q-value of the cantilever 22b.

In the magnetic field obtaining apparatus 1b, the cantilever 22b is excited up and down at a resonant frequency with piezoelectricity of the vibrating part 25. The cantilever 22b is irradiated with light from the LD module 23, and the position of reflected light is detected by the PSPD 24. As a result, the signal processing part 53 (see Fig. 2) detects the amount of shift of the resonant frequency of the cantilever 22b caused by interaction with the sample 9. Here, the shift amount of the frequency at which the cantilever vibrates is derived from interaction and can be said as a measurement amount derived from a conservative force gradient. Accordingly, in the magnetic field obtaining apparatus 1b, when the measuring part 21b performs scanning in the X' direction, a value that indicates a magnetic force gradient (magnetic force gradient in the entire measuring part 21b) is obtained at each position in the X' direction, based on the shift amount of the resonant frequency of the cantilever 22b. Accordingly, measured values f(x', θ) are obtained by repeating scanning in the direction perpendicular to the longitudinal direction of the measuring part 21b on the measurement plane while changing the angle θ formed by the reference direction on a measurement plane that satisfies z = a and the longitudinal direction (Y' direction) of the measuring part 21b to a plurality of angles. Also, $\phi$ (x, y, α) that indicates a magnetic field gradient distribution image is obtained using a technique similar to that used in the magnetic field obtaining apparatus 1 in Fig. 2.

In the measurement performed by the magnetic field obtaining apparatus 1b, the shift amount of the oscillation frequency of the cantilever 22b is obtained on the measurement plane that satisfies z = 0, and then a magnetic field gradient distribution image is obtained as a first image (Fig. 6: step S21). Similarly, a magnetic field gradient distribution image is obtained as an intermediate image on a measurement plane that is away from the former measurement plane by a small distance (step S22). Following this, a difference image between the first image and the intermediate image is divided by the small distance d so as to obtain a differential image that indicates a differential in the magnetic field gradient with respect to z, as a second image (step S23). In this case, since the first image corresponds to $\phi$ (x, y, 0) (i.e., $\Phi_{zz}$(x, y, 0)) and the second image corresponds to $\phi_z$(x, y, 0) (i.e., $\Phi_{zzz}$(x, y, 0)), these images are Fourier transformed and substituted into the three-dimensional potential obtaining equation of Equation 20 so as to obtain $\phi$ (x, y, z) that is $\Phi_{zz}$(x, y, z) (steps S24 and S25). Then, a value that indicates the position of the surface of the sample 9 is substituted into z of $\phi$(x, y, z) so as to obtain a magnetic field gradient distribution on the surface, based on which a magnetic domain image is generated (step S26).

In this way, in the magnetic field obtaining apparatus 1b, measured values f(x', θ) based on a potential derived by differentiating a magnetic potential twice with respect to the Z direction are obtained by the measuring part 21b, which

realizes generation of $\phi$ (x, y, z) that is $\Phi_{zz}$(x, y, z). Of course, the magnetic field obtaining apparatus 1b may also be configured such that a measuring part capable of obtaining a measured value based on a potential derived by differentiating a magnetic potential three or more times with respect to the Z direction is provided, and a potential that is derived by differentiating the magnetic potential three or more times with respect to the Z direction is obtained as $\phi$ (x, y, z).

As described above, in the magnetic field obtaining apparatus, a potential that is derived by differentiating a magnetic potential once or more times with respect to the Z direction is obtained as $\phi$ (x, y, z), and a value that indicates either the position of the surface of the sample 9, which is an object, or a position close to that surface is substituted into z of $\phi$ (x, y, z). Accordingly, it is possible to realize a high-resolution magnetic field microscope.

Note that the magnetic field obtaining apparatus 1b in Fig. 12 may be configured such that the amount of displacement of the cantilever 22b is obtained by the LD module 23 and the PSPD 24 while the cantilever 22b that is not caused to vibrate performs scanning, so that the measuring part 21b obtains measured values f(x', θ) based on a potential derived by differentiating a magnetic potential once with respect to the Z direction and thereby obtains $\phi$ (x, y, z) that is $\Phi_z$(x, y, z) (the same applies to an MRI apparatus described later).

The magnetic field obtaining apparatus 1b may also be configured such that $\Phi_z$(x, y, 0) is measured by scanning with the cantilever 22b that is not caused to vibrate, $\Phi_{zz}$(x, y, 0) is measured by scanning with the cantilever 22b that is caused to vibrate, then $\Phi_z$(x, y, 0) that is set as $H_z^{(q)}$(x, y, 0) (where q = 1) and $\Phi_{zz}$(x, y, 0) that is set as $H_z^{(p)}$(x, y, 0) (where p = 2) are Fourier transformed so as to obtain $h^{(q)}(k_x, k_y)$ and $h^{(p)}(k_x, k_y)$, and then $H_z^{(p)}$(x, y, z) (i.e., $\Phi_{zz}$(x, y, z)) is obtained using Equation 23. In the case where $\Phi_{zz}$(x, y, 0) and $\Phi_{zzz}$(x, y, 0) can be obtained by measurement, a configuration is also possible in which $\Phi_{zzz}$(x, y, 0) that is set as $H_z^{(q)}$(x, y, 0) (where q = 3) and $\Phi_{zz}$(x, y, 0) that is set as $H_z^{(p)}$(x, y, 0) (where p = 2) are Fourier transformed so as to obtain $h^{(q)}(k_x, k_y)$ and $h^{(p)}(k_x, k_y)$, and then $H_z^{(q)}$(x, y, z) (i.e., $\Phi_{zzz}$(x, y, z)) is obtained using Equation 22.

In this way, in the case where $\phi$ (x, y, a) obtained by one measurement is $H_z^{(q)}$(x, y, 0) that is obtained by differentiating an arbitrary potential H(x, y, z) on a measurement plane that satisfies z = 0 q times with respect to z, and $\phi$ (x, y, α) obtained by another measurement is $H_z^{(p)}$(x, y, 0) that is obtained by differentiating the potential H(x, y, z) p times with respect to z (where p and q are integers greater than or equal to 0, q being odd and p being even), $H_z^{(q)}$(x, y, 0) and $H_z^{(p)}$(x, y, 0) are respectively Fourier transformed so as to obtain $h_z^{(q)}(k_x, k_y)$ and $h_z^{(p)}(k_x, k_y)$ (where $k_x$ and $k_y$ are respectively wavenumbers in the X direction and the Y direction). As a result, it is possible to obtain $H_z^{(q)}$(x, y, z) using Equation 22 or $H_z^{(p)}$(x, y, z) using Equation 23 (the same applies to other apparatuses).

The magnetic field obtaining apparatus 1b in Fig. 12 may be used as an MRI apparatus. In this case, the static magnetic field forming part 11 and transmission coil 12 in Fig. 10 are additionally provided in the magnetic field obtaining apparatus 1b, so that nuclear magnetic resonance is sequentially induced inside an object on a plurality of planes located at a plurality of positions in the Z direction. When nuclear magnetic resonance has been induced on each plane included in the plurality of planes, $\phi$ (x, y, z, t) that is $\Phi_{zz}$(x, y, z, t) is obtained, and a relaxation phenomenon at each position (x, y) on that plane is further obtained by substituting a value that indicates a position of the plane into z of $\phi$ (x, y, z, t). As a result, it is possible to obtain a high-precision MRI image on the inspection target surface of the object.

Alternatively, such a magnetic field obtaining apparatus may be provided with a measuring part that is capable of obtaining a measured value based on a potential derived by differentiating a magnetic potential three or more times with respect to the Z direction, and may obtain a potential derived by differentiating a magnetic potential three or more times with respect to the Z direction, as $\phi$ (x, y, z, t). As described above, the magnetic field obtaining apparatus realizes high-precision inspection using nuclear magnetic resonance as a result of obtaining a potential that is derived by differentiating a magnetic potential once or more times with respect to the Z direction, as $\phi$ (x, y, z).

A three-dimensional potential (i.e., $\phi$ (x, y, z) obtained using the three-dimensional potential obtaining equation) that provides a basis for a two-dimensional potential $\phi$ (x, y, α) obtained using the two-dimensional potential obtaining equation is not limited to a potential derived from a magnetic potential, and may be a three-dimensional potential distribution of a potential derived from an electric potential that is easy to apply the two-dimensional potential obtaining method. In this case, for example in the apparatus shown in Fig. 12, the sample 9 is assumed to have electric charge on its surface. A measuring part 21b where its surface is covered with an insulator and the insulator holds electric charge is prepared. Then, at each angle θ, the amount of displacement of the cantilever 22b is obtained as a measured value by the LD module 23 and the PSPD 24 while the cantilever 22b that is not caused to vibrate performs scanning. As a result, $\phi$ (x, y, α) that indicates a two-dimensional potential distribution, i.e., an electrostatic force distribution image that indicates the distribution of (the Z-directional component of) an electrostatic force due to the presence of the sample 9, is obtained.

When obtaining $\phi$ (x, y, z) that indicates a three-dimensional potential distribution (where $\phi$ (x, y, z) satisfies the Laplace equation), a difference between two electrostatic force distribution images on measurement planes whose positions are different from each other by a small distance in the Z direction is divided by the small distance so as to obtain an electrostatic force gradient distribution image, and the electrostatic force distribution image on the measurement plane that satisfies z = 0 and the electrostatic force gradient distribution image are respectively Fourier transformed and substituted into the three-dimensional potential obtaining equation so as to reproduce a three-dimensional potential that indicates an electrostatic force. Furthermore, a value of z that indicates the position of the surface of the sample 9 (or a position close to the surface) is substituted into the reproduced potential function so as to obtain an image that indicates the distribution of the electrostatic force on the surface of the sample 9 as an image corresponding to the distribution of electric charge. In this way, with the above-described technique, a potential distribution that precisely reflects a three-dimensional distribution of electric charge can be obtained from a position that is sufficiently away from the sample 9, without being affected by short range interaction. For example, when electric charge is distributed in three dimensions in an insulating film, it is possible to specify a position at which the electric charge is trapped, from a field that is formed far away by the electric charge.

Of course, the electrostatic force gradient distribution image may be obtained as $\phi$ (x, y, $\alpha$) from the shift amount of the oscillation frequency of the resonating cantilever 22b. Alternatively, $\phi$ (x, y, z) that indicates a three-dimensional distribution of the electrostatic force gradient may be derived based on two electrostatic force gradient distribution images on measurement planes whose positions are different from each other by a small distance in the Z direction.

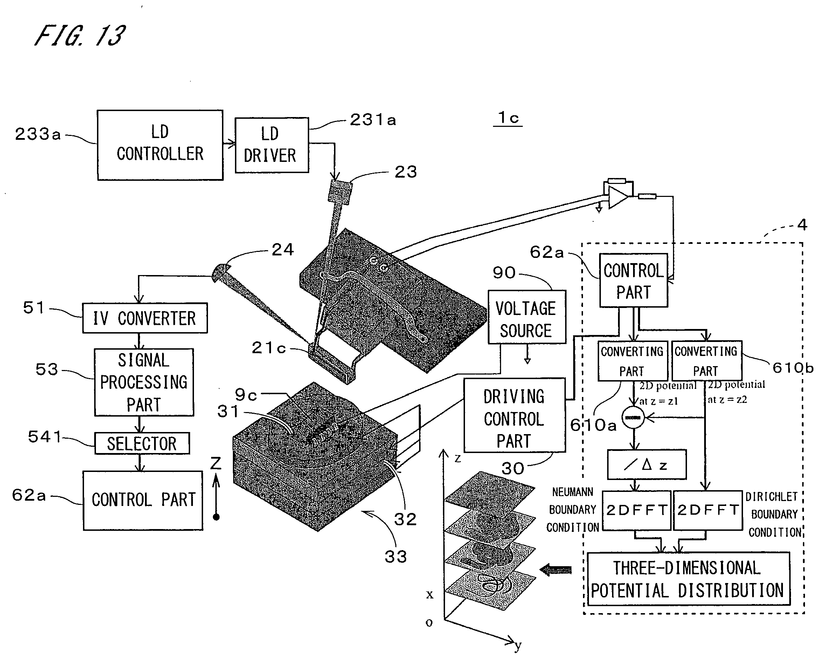

The above-described two- and three-dimensional potential obtaining methods are applicable to an arbitrary three-dimensional potential formed at least in the periphery of an object due to the presence of the object, and can also be applied to, besides the potentials derived from magnetic and electric potentials, potentials derived from temperature, and the like. For example, a measuring part capable of measuring an average temperature in a measurement range that is long in one direction (the temperature being considered to be equivalent to an integrated value of temperatures in that measurement range) is disposed in the vicinity of an object. Then, the steady-state flow of heat is induced in the object, and scanning with the measuring part is repeated while changing an angle $\theta$ formed by a reference direction on a measurement plane and the longitudinal direction of the measuring part to a plurality of angles. As a result, $\theta$ (x, y, $\alpha$) that indicates a temperature distribution on the measurement plane can be obtained. It is also possible, by obtaining temperature distributions on two measurement planes whose positions are diffrent from each other by a small distance in the Z direction, to obtain a three-dimensional temperature distribution $\phi$ (x, y, z) in an object and thereby know the internal structure of the object. Fig. 13 shows one example of a three-dimensional temperature distribution obtaining apparatus 1c capable of performing such measurement.

The temperature distribution obtaining apparatus 1c in Fig. 13 includes a measuring part 21c having a thin-film thermocouple. The thin-film thermocouple is formed by, for example, sequentially laminating platinum (Pt) and constantan on a substrate. A signal from the measuring part 21c is input via an amplifier to a computer 4 similar to that in the apparatus shown in Fig. 2. In Fig. 13, the computer 4 is shown by a broken-line rectangle, and functions realized by the computer 4 are shown in that rectangle. An object 9c to be measured is placed on a sample stage 31 that is rotatable and movable by a rotating mechanism 32 and a horizontal moving mechanism 33. Note that the object 9c is connected to a voltage source 90, and therefore, the steady-state flow of heat is induced in the object 9c.

The measuring part 21c is movable in the Z direction by an elevating mechanism not shown, and an output from the measuring part 21c is input via a control part 62a to converting parts 610a and 610b. In the converting parts 610a and 610b, two-dimensional temperature distributions are obtained at two positions in the Z direction in the same manner as in the apparatus shown in Fig. 2. Then, a three-dimensional temperature distribution (three-dimensional potential distribution) $\phi$ (x, y, z) in the object 9c is obtained based on the two two-dimensional temperature distributions. Note that, like the apparatus in Fig. 2, the temperature distribution obtaining apparatus 1c is provided with an LD module 23 and a PSPD 24, and laser light is emitted from the LD module 23 by an LD controller 233a driving an LD driver 231a. An output from the PSPD 24 is input to the control part 62a via an IV converter 51, a signal processing part 53, and a selector 541 (although in Fig. 13, for convenience of illustration, this control part 62a is shown as a different block from the one connected to the measuring part 21c, both of the blocks indicate the same control part 62a). This prevents the measuring part 21c from coming into contact with the object 9c.

While the above has been a description of embodiments of the present invention, the present invention is not intended to be limited to the embodiments described above and can be modified in various ways.

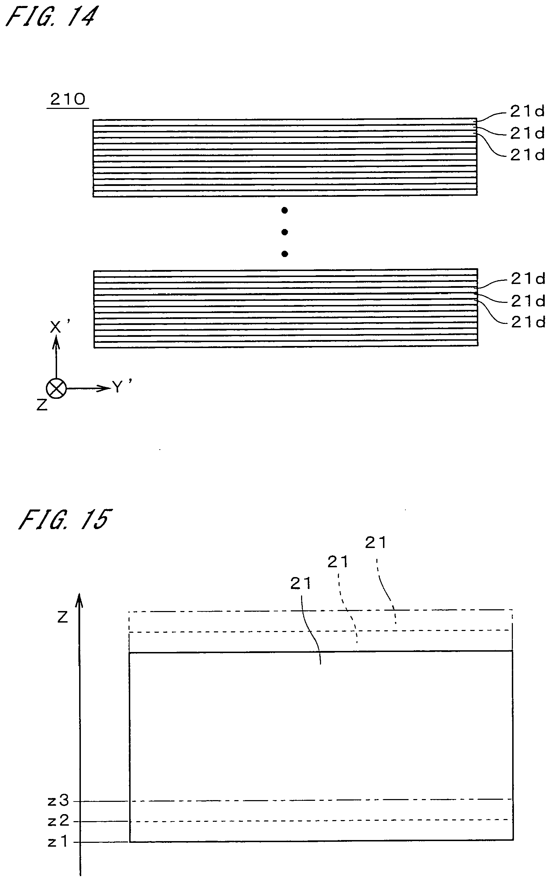

Although in the above-described embodiments, a measurement unit that obtains measured values f(x', $\theta$) is realized by a measuring part, a rotating mechanism, a horizontal moving mechanism, and a computer (or a control part), the measurement unit may be realized by other configurations. Fig. 14 is a bottom view of an element group 210 provided in another measurement unit. As shown in Fig. 14, in the element group 210 in which a large number of thin film elements 21d, each serving as a sensor that extends in the longitudinal direction, are laminated in the film thickness direction, measured values at respective positions in the X' direction at one angle $\theta$ are obtained at the same time. Then, the measurement with the element group 210 is repeated while rotating the element group 210 or an object about the Z axis and thereby changing the angle $\theta$ to a plurality of angles, so as to obtain the measured values f(x', $\theta$).

Here, if an area of each thin film element 21d on a measurement plane is taken as a linear area, the element group 210 is configured to simultaneously obtain measured values in a plurality of linear areas that are arranged in the X' direction perpendicular to the longitudinal direction and parallel to the measurement plane. Furthermore, in the measurement unit of the above-described embodiments in which the measuring part performs scanning, the operation of scanning performed by the measuring part that is long in the longitudinal direction is equivalent to setting a plurality of linear areas such that the linear areas are arranged in the X' direction at one angle θ and then obtaining a measured value in each of the plurality of linear areas. As described above, the potential obtaining apparatus for obtaining $\phi$ (x, y, α) can realize, in various forms, the measurement unit in which a plurality of linear areas that extend in the longitudinal direction parallel to a measurement plane are set such that the linear areas are arranged in the X' direction perpendicular to the longitudinal direction on the measurement plane, and that is for obtaining a measured value in each of the plurality of linear areas in a state in which the angle θ formed by the reference direction and the longitudinal direction is changed to a plurality of angles.

When the magnetic field obtaining apparatus 1 in Fig. 2 (as well as the other apparatuses) obtains the magnetic field distribution image 71 and the auxiliary magnetic field distribution image 72 at two positions that are away from each other by a small distance d in the Z direction, if the width (height) of the measuring part 21 in the Z direction is sufficiently greater than the small distance d, measurement may be performed by, for example, sequentially disposing the bottom face of the measuring part 21 at three heights z1, z2, and z3 in the Z direction as shown in Fig. 15. In this case, if images obtained at the heights z1, z2, and z3 are respectively referred to as a z1 image $\phi$ (x, y, z1), a z2 image $\phi$ (x, y, z2), and a z3 image $\phi$ (x, y, z3), a difference image between the z1 image $\phi$ (x, y, z1) and the z2 image $\phi$ (x, y, z2) is treated as a magnetic field distribution image, and a difference image between the z2 image $\phi$ (x, y, z2) and the z3 image $\phi$ (x, y, z3) is treated as an auxiliary magnetic field distribution image. This makes it possible to obtain a magnetic field distribution image and an auxiliary magnetic field distribution image that are equivalent to those obtained by performing measurement using a measuring part whose width in the Z direction is small, thus allowing a three-dimensional magnetic field distribution to be obtained with high precision. Note that when using this technique, it is important to make sure that a magnetic field formed due to the presence of the sample 9 is substantially 0 in a portion of the measuring part 21 that is farthest from the sample 9. Alternatively, depending on the design of the measuring part, this technique may be adopted in the X' direction perpendicular to both the longitudinal direction and the Z direction.

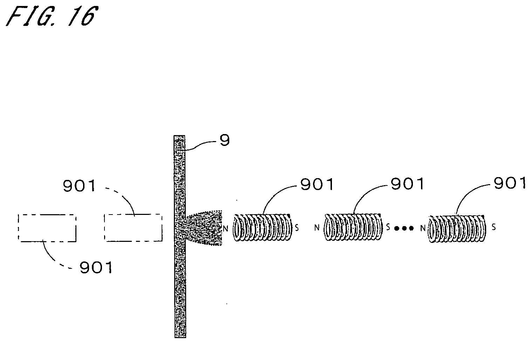

When it is necessary, in the measurement of a magnetic field, to magnetize the sample 9 (e.g., sample of a ferromagnetic or ferrimagnetic material) in advance, it is preferable to increase the directivity of a magnetic field at the time of magnetization by arranging a plurality of coils 901 in a direction perpendicular to the sample 9 as shown in Fig. 16 (disposing the coils in multiple stages). As a result, only a limited range can be magnetized (a magnetically oriented area is prevented from spreading in a wide range), and preferable measurement is possible. Note that when a plate-like sample 9 can be magnetized from both main surface sides, the directivity of a magnetic field at the time of magnetization may be further increased by providing, besides the plurality of coils 901 provided on one main surface side, a plurality of similar coils 901 on the other main surface side as indicated by dashed double-dotted line rectangles in Fig. 16.

In the magnetic field obtaining apparatus, the speed of measuring a three-dimensional potential may be increased by aligning the support part 22 in Fig. 2 and the cantilever 22b in Fig. 12 in the scanning direction so that the magnetic field distribution image and the magnetic field gradient distribution image are obtained substantially at the same time.

Two- and three-dimensional potentials do not necessarily have to be obtained in strict accordance with the above-described two- and three-dimensional potential obtaining equations, and may be obtained as appropriate through similar, approximate, or modified computations. It is also possible to employ various well-known skillful techniques for Fourier and inverse-Fourier transforms.

In the above-described embodiments, by forming the measuring parts 21 and 21a to 21c as thin-film elements that spread in the Y' direction and the Z direction, it is possible to improve the resolution of measurement in the scanning direction during scanning with the measuring parts 21 and 21a to 21c and to further improve the resolution of measuring a two-dimensional potential. However, depending on the resolution required for a two-dimensional potential to be measured, it is possible to use a measuring part that extends in parallel to a measurement plane and that is relatively thick in the scanning direction.

Configurations are possible in which the measuring part 21 in the magnetic field obtaining apparatus 1 in Fig. 2 is rotated around the Z axis, and the member for supporting the object 9a in the inspection apparatus 1a in Fig. 10 is rotated around the Z axis. Configurations are also possible in which the measuring part 21 in Fig. 2 is moved on a measurement plane, and the member for supporting the object 9a in Fig. 10 is moved in the horizontal direction together with the object 9a. In this way, it is sufficient for the rotation and movement of the measuring part on a measurement plane to be relative to an object.

Although in the above-described embodiments, the measuring parts 21, 21a, and 21b are moved in the Z direction by the elevating mechanisms 34 and 34a, it is sufficient for the movement of the measuring part in the Z direction to be relative to an object. An elevating mechanism for moving an object in the Z direction may be provided as a Z-directional moving mechanism.

The configurations of the above-described preferred embodiments and variations may be appropriately combined as long as there are no mutual inconsistencies.

While the invention has been shown and described in detail, the foregoing description is in all aspects illustrative and not restrictive. It is therefore understood that numerous modifications and variations can be devised without departing from the scope of the invention.

**Reference Signs List**

| | |
|---|---|
| 1, 1b | Magnetic field obtaining apparatus |
| 1a | Inspection apparatus |
| 1c | Temperature distribution obtaining apparatus |
| 4 | Computer |
| 9 | Sample |
| 9a, 9c | Object |
| 11 | Static magnetic field forming part |
| 12 | Transmission coil |
| 21, 21a to 21c | Measuring part |
| 32, 32a | Rotating mechanism |
| 33, 33a | Horizontal moving mechanism |
| 34, 34a | Elevating mechanism |
| 61, 63 | Computing part |
| 62, 62a | Control part |
| 71 | Magnetic field distribution image |
| 72 | Auxiliary magnetic field distribution image |
| 81 | Evaporation source |
| 91, 92 | Measurement plane |
| 93 | Surface (of sample) |
| 220 | Thin film |
| 221 | Substrate |
| S11 to S14, S21 to S25 | Step |

**Claims**

1. A potential obtaining apparatus (1, 1a to 1c) for, assuming that $\phi(x, y, z)$ is a potential function that indicates a three-dimensional potential formed at least in the periphery of an object (9, 9a, 9c) due to the presence of said object, where x, y, and z are coordinate parameters of a rectangular coordinate system defined in mutually perpendicular X, Y, and Z directions that are set for said object, obtaining $\phi(x, y, \alpha)$ on a measurement plane (91, 92) that is set outside said object and satisfies z = $\alpha$, where $\alpha$ is an arbitrary value, said apparatus comprising:

   a measurement unit in which a plurality of linear areas that extend in a longitudinal direction parallel to said measurement plane that is parallel to an XY plane are set so as to be arranged in an X' direction perpendicular to said longitudinal direction on said measurement plane, and that is for obtaining, by a sensor extending in said longitudinal direction, a measured value derived from said three-dimensional potential in each of said plurality of linear areas in a state in which an angle θ formed by the Y direction and said longitudinal direction has been changed to a plurality of angles; and
   a computing part (61, 63) for, assuming that x' is a coordinate parameter in the X' direction, where an origin is on a Z axis, obtaining $\phi(x, y, \alpha)$ on the measurement plane (91, 92) using the measured values f(x', θ) obtained by said measurement unit from Equation 24,

   **[Equation 24]**

   $$\phi(x,y,\alpha) = \iint \left[ \int f(x',\theta) exp(-ik_{x'}x')dx' \right] exp(ik_{x'}(x\cos\theta + y\sin\theta))k_{x'}dk_{x'}d\theta$$

   where $k_{x'}$ is a wavenumber in the X' direction,
   wherein said measurement unit includes:

a measuring part (21, 21a to 21c) which is said sensor, said measuring part being a thin-film element that spreads in said longitudinal direction and the Z direction and being configured to generate a signal derived from said three-dimensional potential;

an angle changing part (32, 32a) for changing said angle θ formed by the Y direction and said longitudinal direction of said measuring part;

a moving mechanism (33, 33a) for moving said measuring part in the X' direction relative to said object on said measurement plane such that scanning is performed in which said measuring part is adapted to pass through over a measurement area of said object; and

a control part (4, 62, 62a) for controlling said angle changing part and said moving mechanism such that said scanning is repeated while said angle θ is changed to a plurality of angles,

wherein said measurement unit is adapted to obtain measured values f(x', θ) by repetitions of said scanning, wherein the potential obtaining apparatus further comprises:

another moving mechanism (34, 34a) for moving said measuring part in the Z direction relative to said object, wherein said three-dimensional potential satisfies the Laplace equation,

wherein said control part is adapted to obtain $\phi(x, y, 0)$ on said measurement plane that satisfies z = 0 as a two-dimensional first image (71), and after said measuring part is moved by a small distance in the Z direction relative to said object, to obtain a two-dimensional intermediate image (72) using a technique similar to that used to obtain said first image, and

said computing part is adapted to obtain a difference image between said first image and said intermediate image, to divide said difference image by said small distance so as to obtain a differential image as a second image, to Fourier transform $\phi(x, y, 0)$ serving as said first image and $\phi_z(x, y, 0)$ serving as said second image so as to obtain $\psi(k_x, k_y)$ and $\psi_z(k_x, k_y)$, where $k_x$ and $k_y$ are respectively wavenumbers in the X direction and the Y direction, and then to obtain $\phi(x, y, z)$ from Equation 25 using $\psi(k_x, k_y)$ and $\psi z(k_x, k_y)$.

[Equation 25]

$$
\phi(x,y,z)
$$
$$
= \iint exp(ik_x x + ik_y y)\left\{ \frac{1}{2}\left[ \phi(k_x,k_y) + \frac{\phi_z(k_x,k_y)}{\sqrt{k_x^2 + k_y^2}} \right] exp(z\sqrt{k_x^2 + k_y^2}) \right.
$$
$$
\left. + \frac{1}{2}\left[ \phi(k_x,k_y) - \frac{\phi_z(k_x,k_y)}{\sqrt{k_x^2 + k_y^2}} \right] exp(-z\sqrt{k_x^2 + k_y^2}) \right\} dk_x dk_y
$$

2. The potential obtaining apparatus according to claim 1, wherein
$\phi(x, y, z)$ corresponds to a function derived by differentiating said three-dimensional potential one or more times with respect to the Z direction.

3. The potential obtaining apparatus according to claim 1, wherein
a film thickness of said thin-film element gradually decreases in a direction along a surface of said thin-film element, the direction being perpendicular to said longitudinal direction.

4. The potential obtaining apparatus according to any one of claims 1 to 3, wherein
said three-dimensional potential is a potential derived from a magnetic potential, an electric potential, or a temperature field.

5. A magnetic field microscope (1) comprising:

the potential obtaining apparatus according to claim 1 for obtaining a function derived by differentiating a magnetic potential once or more times with respect to the Z direction, as $\phi(x, y, z)$,

wherein said computing part is adapted to substitute a value that indicates either a position of a surface of said object or a position close to said surface into z of $\phi(x, y, z)$.

6. An inspection apparatus (1a) using nuclear magnetic resonance, comprising:

the potential obtaining apparatus according to claim 1 for obtaining a function derived by differentiating a magnetic potential once or more times with respect to the Z direction, as $\phi$ (x, y, z); and

means (11, 12) for sequentially inducing nuclear magnetic resonance inside said object on a plurality of planes located at a plurality of positions in the Z direction,

wherein said control part is adapted to obtain $\phi$(x, y, z) when nuclear magnetic resonance is induced on each plane included in said plurality of planes, and

said computing part is adapted to substitute a value that indicates a position of said each plane into z of $\phi$ (x, y, z) obtained for said each plane.

7. A potential obtaining method for, assuming that $\phi$(x, y, z) is a potential function that indicates a three-dimensional potential formed at least in the periphery of an object (9, 9a, 9c) due to the presence of said object, where x, y, and z are coordinate parameters of a rectangular coordinate system defined in mutually perpendicular X, Y, and Z directions that are set for said object, obtaining $\phi$(x, y, $\alpha$) on a measurement plane (91, 92) that is set outside said object and satisfies z = $\alpha$, where $\alpha$ is an arbitrary value,

said method comprising the steps of:

a) (S11 to S13) setting a plurality of linear areas that extend in a longitudinal direction parallel to said measurement plane that is parallel to an XY plane such that said plurality of linear areas are arranged in an X' direction perpendicular to said longitudinal direction on said measurement plane, and obtaining, by a sensor extending in said longitudinal direction, a measured value derived from said three-dimensional potential in each of said plurality of linear areas in a state in which an angle θ formed by the Y direction and said longitudinal direction has been changed to a plurality of angles; and

b) (S14) assuming that x' is a coordinate parameter in the X' direction, where an origin is on a Z axis, obtaining $\phi$(x, y, $\alpha$) on the measurement plane (91, 92) using the measured values f(x', θ) obtained in said step a) from Equation 26,

[Equation 26]

$$\phi(x,y,\alpha) = \iint \left[ \int f(x',\theta) exp(-ik_{x'}x')dx' \right] exp(ik_{x'}(x\cos\theta + y\sin\theta))k_{x'}dk_{x'}d\theta$$

where $k_{x'}$ is a wavenumber in the X' direction,
wherein said step a) includes the steps of:

a1) (S11) moving a measuring part (21, 21a to 21c) in the X' direction relative to said object on said measurement plane such that scanning is performed in which said measuring part is adapted to pass through over a measurement area of said object, said measuring part being said sensor and being a thin-film element that spreads in said longitudinal direction and the Z direction and generates a signal derived from said three-dimensional potential; and

a2) (S12 to S13) obtaining measured values f(x', θ) by repetitions of said step a1) while changing said angle θ formed by the Y axis and said longitudinal direction of said measuring part to a plurality of angles,

wherein said three-dimensional potential satisfies the Laplace equation and said measurement plane satisfies z = 0,

wherein $\phi$(x, y, 0) is obtained as a two-dimensional first image (71) in said steps a) and b), and

wherein said potential obtaining method comprises the steps of:

c) (S22) after said measuring part is moved by a small distance in the Z direction relative to said object, obtaining a two-dimensional intermediate image (72) using a method similar to that used to obtain said first image;

d) (S23) obtaining a difference image between said first image and said intermediate image and dividing said difference image by said small distance so as to obtain a differential image as a second image;

e) (S24) Fourier transforming $\phi$(x, y, 0) serving as said first image and $\phi_z$(x, y, 0) serving as said second image so as to obtain $\psi$($k_x$, $k_y$) and $\psi_z$($k_x$, $k_y$), where $k_x$ and $k_y$ are respectively wavenumbers in the X direction and the Y direction; and

f) (S25) obtaining $\phi$(x, y, z) from Equation 27 using $\psi$($k_x$, $k_y$) and $\psi_z$($k_x$, $k_y$).

[Equation 27]

$$\phi(x,y,z)$$

$$= \int\!\!\int exp(ik_x x + ik_y y)\left\{\frac{1}{2}\left[\phi(k_x,k_y)+\frac{\psi_z(k_x,k_y)}{\sqrt{k_x^2+k_y^2}}\right]exp(z\sqrt{k_x^2+k_y^2})\right.$$

$$\left.+\frac{1}{2}\left[\phi(k_x,k_y)-\frac{\psi_z(k_x,k_y)}{\sqrt{k_x^2+k_y^2}}\right]exp(-z\sqrt{k_x^2+k_y^2})\right\}dk_x dk_y$$

8. The potential obtaining method according to claim 7, wherein
$\phi(x, y, z)$ corresponds to a function derived by differentiating said three-dimensional potential once or more times with respect to the Z direction.

9. The potential obtaining method according to any one of claims 7 and 8, wherein
said three-dimensional potential is a potential derived from a magnetic potential, an electric potential, or a temperature field.

**Patentansprüche**

1. Potentialgewinnungsvorrichtung (1, 1a bis 1c) zum, unter der Annahme, dass $\phi(x, y, z)$ eine Potentialfunktion ist, die ein dreidimensionales Potential angibt, das zumindest in der Peripherie eines Objekts (9, 9a, 9c) aufgrund des Vorhandenseins des Objekts gebildet wird, wobei x, y und z Koordinatenparameter eines rechteckigen Koordinatensystems sind, das in zueinander senkrechten X-, Y- und Z-Richtungen definiert ist, die für das Objekt festgelegt sind, Gewinnen von $\phi(x, y, a)$ auf einer Messebene (91, 92), die außerhalb des Objekts festgelegt ist und z = $\alpha$ erfüllt, wobei $\alpha$ ein beliebiger Wert ist,
wobei die Vorrichtung umfasst:

eine Messeinheit, in der eine Mehrzahl linearer Bereiche, die sich in einer Längsrichtung parallel zu der Messebene erstrecken, die parallel zu einer XY-Ebene ist, so festgelegt sind, dass sie in einer X'-Richtung senkrecht zu der Längsrichtung auf der Messebene angeordnet sind, und die zum Gewinnen, durch einen Sensor, der sich in der Längsrichtung erstreckt, eines gemessenen Werts ist bzw. dient, der aus dem dreidimensionalen Potential in jedem der Mehrzahl linearer Bereiche in einem Zustand abgeleitet wird, in dem ein Winkel θ, der durch die Y-Richtung und die Längsrichtung gebildet wird, zu einer Mehrzahl von Winkeln geändert wurde; und einen Rechenteil (61, 63) zum, unter der Annahme, dass x' ein Koordinatenparameter in der X'-Richtung ist, wobei sich ein Ursprung auf einer Z-Achse befindet, Gewinnen von $\phi(x, y, \alpha)$ auf der Messeebene (91, 92) unter Verwendung der gemessenen Werte f(x', θ), die von der Messeinheit aus Gleichung 24 gewinnen werden,

[Gleichung 24]

$$\phi(x,y,\alpha)=\int\!\!\int\left[\int f(x',\theta)exp(-ik_{x'}x')dx'\right]exp(ik_{x'}(x\cos\theta+y\sin\theta))k_{x'}dk_{x'}d\theta$$

wobei $k_{x'}$ eine Wellenzahl in der X' Richtung ist,
wobei die Messeinheit enthält:

einen Messteil (21, 21a bis 21c), bei dem es sich um den Sensor handelt, wobei der Messteil ein Dünnschichtelement ist, das sich in der Längsrichtung und der Z-Richtung ausbreitet bzw. verteilt und konfiguriert ist, ein Signal zu erzeugen, das aus dem dreidimensionalen Potential abgeleitet wird;
einen Winkeländerungsteil (32, 32a) zum Ändern des Winkels θ, der durch die Y-Richtung und die Längsrichtung des Messteils gebildet wird;
einen Bewegungsmechanismus (33, 33a) zum Bewegen des Messteils in der X'-Richtung relativ zu dem Objekt auf der Messebene, so dass ein Abtasten durchgeführt wird, bei dem der Messteil angepasst ist, über bzw. durch einen Messbereich des Objekts zu laufen; und

einen Steuer- bzw. Regelteil (4, 62, 62a) zum Steuern bzw. Regeln des Winkeländerungsteils und des Bewegungsmechanismus, so dass das Abtasten wiederholt wird, während der Winkel $\theta$ zu einer Mehrzahl von Winkeln geändert wird,

wobei die Messeinheit angepasst ist, gemessene Werte f(x', $\theta$) durch Wiederholungen des Abtastens zu gewinnen,
wobei die Potentialgewinnungsvorrichtung ferner umfasst:

einen anderen bzw. weiteren Bewegungsmechanismus (34, 34a) zum Bewegen des Messteils in der Z-Richtung relativ zu dem Objekt;
wobei das dreidimensionale Potential die Laplace-Gleichung erfüllt,
wobei der Steuer- bzw. Regelteil angepasst ist, $\phi$(x, y, 0) auf der Messebene zu gewinnen, die z = 0 erfüllt, und zwar als ein zweidimensionales erstes Bild (71), und nachdem der Messteil um eine geringe Distanz in der Z-Richtung relativ zu dem Objekt bewegt wurde, ein zweidimensionales Zwischenbild (72) unter Verwendung einer Technik ähnlich der zu gewinnen, die verwendet wird, um das erste Bild zu gewinnen, und wobei der Rechenteil angepasst ist, ein Differenzbild zwischen dem ersten Bild und dem Zwischenbild zu gewinnen, das Differenzbild durch die geringe Distanz zu teilen, um ein Differenzbild als ein zweites Bild zu gewinnen, um $\phi$(x, y, 0), der als das erste Bild dient, und $\phi_z$(x, y, 0), der als das zweite Bild dient, einer Fourier-Transformation zu unterziehen, um $\psi$(k$_x$, k$_y$) und $\psi_z$(k$_x$, k$_y$) zu gewinnen, wobei k$_x$ und k$_y$ Wellenzahlen in der X-Richtung bzw. der Y-Richtung sind, und dann $\phi$(x, y, z) aus Gleichung 25 unter Verwendung von $\psi$(k$_x$, k$_y$) und $\psi_z$(k$_x$, k$_y$) zu gewinnen.

[Gleichung 25]

$$\phi(x,y,z)$$
$$= \iint exp(ik_x x + ik_y y)\left\{\frac{1}{2}\left[\phi(k_x,k_y) + \frac{\psi_z(k_x,k_y)}{\sqrt{k_x^2+k_y^2}}\right]exp(z\sqrt{k_x^2+k_y^2})\right.$$
$$\left. + \frac{1}{2}\left[\phi(k_x,k_y) - \frac{\psi_z(k_x,k_y)}{\sqrt{k_x^2+k_y^2}}\right]exp(-z\sqrt{k_x^2+k_y^2})\right\}dk_x dk_y$$

2. Potentialgewinnungsvorrichtung nach Anspruch 1, wobei $\phi$(x, y, z) einer Funktion entspricht, die durch einmaliges oder mehrmaliges Differenzieren des dreidimensionalen Potentials in Bezug auf die Z-Richtung abgeleitet wird.

3. Potentialgewinnungsvorrichtung nach Anspruch 1, wobei eine Filmdicke des Dünnschichtelements in einer Richtung entlang einer Fläche bzw. Oberfläche des Dünnschichtelements allmählich abnimmt, wobei die Richtung senkrecht zu der Längsrichtung ist.

4. Potentialgewinnungsvorrichtung nach einem der Ansprüche 1 bis 3, wobei das dreidimensionale Potential ist ein Potential, das von einem magnetischen Potential, einem elektrischen Potential oder einem Temperaturfeld abgeleitet wird.

5. Magnetfeldmikroskop (1), umfassend:

die Potentialgewinnungsvorrichtung nach Anspruch 1 zum Gewinnen einer Funktion, die durch ein- oder mehrmaliges Differenzieren eines magnetischen Potentials in Bezug auf die Z-Richtung abgeleitet wird, als $\phi$(x, y, z), wobei der Rechenteil angepasst ist, einen Wert, der entweder eine Position einer Fläche bzw. Oberfläche des Objekts oder eine Position nahe der Oberfläche angibt, in z von $\phi$(x, y, z) zu substituieren bzw. einzusetzen.

6. Inspektionsvorrichtung (1a), die Kernspinresonanz, umfassend:

die Potentialgewinnungsvorrichtung nach Anspruch 1 zum Gewinnen einer Funktion, die durch einmaliges oder mehrmaliges Differenzieren eines magnetischen Potentials in Bezug auf die Z-Richtung abgeleitet wird, als $\phi$ (x, y, z); und

Mittel (11, 12) zum sequentiellen Induzieren einer Kernspinresonanz innerhalb des Objekts auf einer Mehrzahl von Ebenen, die sich an einer Mehrzahl von Positionen in der Z-Richtung befinden, wobei der Steuer- bzw. Regelteil angepasst ist, $\phi$ (x, y, z) zu gewinnen, wenn eine Kernspinresonanz auf jeder Ebene induziert wird, die in der Mehrzahl von Ebenen enthalten ist, und

wobei der Rechenteil angepasst ist, einen Wert, der eine Position jeder Ebene angibt, in z von $\phi$ (x, y, z) zu substituieren bzw. einzusetzen, der für jede Ebene gewinnen wird.

7. Potentialgewinnungsverfahren zum, unter der Annahme, dass $\phi$ (x, y, z) eine Potentialfunktion ist, die ein dreidimensionales Potential angibt, das zumindest in der Peripherie eines Objekts (9, 9a, 9c) aufgrund des Vorhandenseins des Objekts gebildet wird, wobei x, y und z Koordinatenparameter eines rechteckigen Koordinatensystems sind, das in zueinander senkrechten X-, Y- und Z-Richtungen definiert ist, die für das Objekt festgelegt sind, Gewinnen von $\phi$ (x, y, a) auf einer Messebene (91, 92), die außerhalb des Objekts festgelegt wird und z = $\alpha$ erfüllt, wobei $\alpha$ ein beliebiger Wert ist,

wobei das Verfahren die Schritte umfasst:

a) (S11 bis S13) Festlegen einer Mehrzahl linearer Bereiche, die sich in einer Längsrichtung parallel zu der Messebene erstrecken, die parallel zu einer XY-Ebene ist, derart, dass die Mehrzahl linearer Bereiche in einer X'-Richtung senkrecht zu der Längsrichtung auf der Messebene angeordnet sind, und Gewinnen, durch einen Sensor, der sich in der Längsrichtung erstreckt, eines gemessenen Werts, der aus dem dreidimensionalen Potential in jedem der Mehrzahl linearer Bereiche in einem Zustand abgeleitet wird, in dem ein Winkel $\theta$, der durch die Y-Richtung und die Längsrichtung gebildet wird, zu einer Mehrzahl von Winkeln geändert wurde; und

b) (S14) unter der Annahme, dass x' ein Koordinatenparameter in der X'-Richtung ist, wobei sich ein Ursprung auf einer Z-Achse befindet, Gewinnen von $\phi$ (x, y, $\alpha$) auf der Messeebene (91, 92) unter Verwendung der gemessenen Werte f(x', $\theta$), die in Schritt a) aus Gleichung 26 gewinnen werden,

[Gleichung 26]

$$\phi\,(x,y,\alpha) = \iint \left[ \int f(x',\theta)\,exp(-ik_{x'}x')dx' \right] exp(ik_{x'}(x\cos\theta + y\sin\theta))k_{x'}\,dk_{x'}\,d\theta$$

wobei $k_{x'}$ eine Wellenzahl in der X' Richtung ist,

wobei der Schritt a) die Schritte umfasst:

a1) (S11) Bewegen eines Messteils (21, 21a bis 21c) in der X'-Richtung relativ zu dem Objekt auf der Messebene, so dass ein Abtasten durchgeführt wird, bei dem der Messteil angepasst ist, über bzw. durch einen Messbereich des Objekts zu laufen, wobei der Messteil der Sensor ist und ein Dünnschichtelement ist, das sich in der Längsrichtung und der Z-Richtung ausbreitet bzw. verteilt und ein Signal zu erzeugt, das aus dem dreidimensionalen Potential abgeleitet wird;

a2) (S12 bis S13) Gewinnen von gemessene Werte f(x', $\theta$) durch Wiederholungen des Schritts a1), während der durch die Y-Achse und die Längsrichtung des Messteils gebildete Winkel $\theta$ zu einer Mehrzahl von Winkeln geändert wird,

wobei das dreidimensionale Potential die Laplace-Gleichung erfüllt und die Messebene z = 0 erfüllt, $\phi$ (x, y, 0) als ein zweidimensionales erstes Bild (71) in den Schritten a) und b) gewinnen wird, und

wobei das Potentialgewinnungsverfahren die Schritte umfasst:

c) (S22) nachdem der Messteil um eine geringe Distanz in der Z-Richtung relativ zu dem Objekt bewegt wurde, Gewinnen eines zweidimensionalen Zwischenbildes (72) unter Verwendung eines Verfahrens ähnlich demjenigen, das verwendet wird, um das erste Bild zu gewinnen;

d) (S23) Gewinnen eines Differenzbildes zwischen dem ersten Bild und dem Zwischenbild und Teilen des Differenzbildes durch die geringe Distanz, um ein Differenzbild als ein zweites Bild zu gewinnen;

e) (S24) Durchführen einer Fourier-Transformation an $\phi$ (x, y, 0), der als das erste Bild dient, und an $\phi_z$(x, y, 0), der als das zweite Bild dient, um $\psi$ ($k_x$, $k_y$) und $\psi_z$($k_x$, $k_y$) zu gewinnen, wobei $k_x$ und $k_y$ Wellenzahlen in der X-Richtung bzw. der Y-Richtung sind, und

f) (S25) Gewinnen von $\phi$ (x, y, z) aus Gleichung 27 unter Verwendung von $\psi$ ($k_x$, $k_y$) und $\psi_z$($k_x$, $k_y$) zu gewinnen.

[Gleichung 27]

$$\phi(x,y,z)$$
$$= \iint exp(ik_x x + ik_y y)\left\{ \frac{1}{2}\left[ \phi(k_x,k_y) + \frac{\phi_z(k_x,k_y)}{\sqrt{k_x^2+k_y^2}} \right] exp(z\sqrt{k_x^2+k_y^2}) \right.$$

$$\left. + \frac{1}{2}\left[ \phi(k_x,k_y) - \frac{\phi_z(k_x,k_y)}{\sqrt{k_x^2+k_y^2}} \right] exp(-z\sqrt{k_x^2+k_y^2}) \right\} dk_x dk_y$$

**8.** Potentialgewinnungsverfahren nach Anspruch 7, wobei $\phi$ (x, y, z) einer Funktion entspricht, die durch einmaliges oder mehrmaliges Differenzieren des dreidimensionalen Potentials in Bezug auf die Z-Richtung abgeleitet wird.

**9.** Potentialgewinnungsverfahren nach einem der Ansprüche 7 und 9, wobei das dreidimensionale Potential ist ein Potential, das von einem magnetischen Potential, einem elektrischen Potential oder einem Temperaturfeld abgeleitet wird.

**Revendications**

**1.** Appareil d'obtention de potentiel (1, 1a à 1c) pour, en supposant que ø(x, y, z) est une fonction de potentiel qui indique un potentiel tridimensionnel formé au moins dans la périphérie d'un objet (9, 9a, 9c) en raison de la présence dudit objet, où x, y et z sont des paramètres de coordonnée d'un système de coordonnées rectangulaire défini dans des directions X, Y et Z mutuellement perpendiculaires qui sont réglées pour ledit objet, obtenir ø(x, y, α) sur un plan de mesure (91, 92) qui est réglé en dehors dudit objet et satisfait z = α, où α est une valeur arbitraire, ledit appareil comprenant :

un module de mesure dans lequel une pluralité de zones linéaires qui s'étendent dans une direction longitudinale parallèle audit plan de mesure qui est parallèle à un plan XY sont réglées de manière à être agencées dans une direction X' perpendiculaire à ladite direction longitudinale sur ledit plan de mesure, et qui est destiné à l'obtention, par un capteur s'étendant dans ladite direction longitudinale, d'une valeur mesurée dérivée dudit potentiel tridimensionnel dans chacune de ladite pluralité de zones linéaires dans un état dans lequel un angle θ formé par la direction Y et ladite direction longitudinale a été changé en une pluralité d'angles ; et
une partie de calcul (61, 63) pour, en supposant que x' est un paramètre de coordonnée dans la direction X', où une origine est sur un axe Z, obtenir ø(x, y, a) sur le plan de mesure (91, 92) en utilisant les valeurs mesurées f(x', θ) obtenues par ledit module de mesure à partir de l'Equation 24,

[Equation 24]

$$\phi(x,y,\alpha) = \iint \left[ \int f(x',\theta)exp(-ik_{x'}x')dx' \right] exp(ik_{x'}(x\cos\theta + y\sin\theta))k_{x'}dk_{x'}d\theta$$

où $k_{x'}$ est un nombre d'onde dans la direction X',
dans lequel ledit module de mesure inclut :

une partie de mesure (21, 21a à 21c) qui est ledit capteur, ladite partie de mesure étant un élément de film mince qui s'étale dans ladite direction longitudinale et la direction Z et étant configurée pour générer un signal dérivé dudit potentiel tridimensionnel ;
une partie de changement d'angle (32, 32a) pour changer ledit angle θ formé par la direction Y et ladite direction longitudinale de ladite partie de mesure ;
un mécanisme de déplacement (33, 33a) pour déplacer ladite partie de mesure dans la direction X' par rapport audit objet sur ledit plan de mesure de sorte qu'un balayage est réalisé dans lequel ladite partie de mesure est adaptée à passer sur une zone de mesure dudit objet ; et
une partie de commande (4, 62, 62a) pour commander ladite partie de changement d'angle et ledit mécanisme de déplacement de sorte que ledit balayage est répété tandis que ledit angle $\theta$ est changé en une pluralité d'angles, dans lequel ledit module de mesure est adapté à obtenir des valeurs mesurées f(x', $\theta$) par des répétitions dudit balayage,

dans lequel l'appareil d'obtention de potentiel comprend en outre :

un autre mécanisme de déplacement (34, 34a) pour déplacer ladite partie de mesure dans la direction Z par rapport audit objet,
dans lequel ledit potentiel tridimensionnel satisfait l'équation de Laplace,
dans lequel ladite partie de commande est adaptée à obtenir ø(x, y, 0) sur ledit plan de mesure qui satisfait z = 0 en tant que première image bidimensionnelle (71), et après que ladite partie de mesure est déplacée d'une faible distance dans la direction Z par rapport audit objet, à obtenir une image intermédiaire bidimensionnelle (72) en utilisant une technique similaire à celle utilisée pour obtenir ladite première image, et ladite partie de calcul est adaptée à obtenir une image de différence entre ladite première image et ladite image intermédiaire, à diviser ladite image de différence par ladite faible distance de manière à obtenir une image différentielle en tant que seconde image, à réaliser une transformée de Fourier de ø(x, y, 0) servant en tant que ladite première image et ø$_z$(x, y, 0) servant en tant que ladite seconde image de manière à obtenir $\psi$(k$_x$, k$_y$) et $\psi_z$(k$_x$, k$_y$), où k$_x$ et k$_y$ sont respectivement des nombres d'onde dans la direction X et la direction Y, puis de manière à obtenir ø(x, y, z) à partir de l'Equation 25 en utilisant $\psi$(k$_x$, k$_y$) et $\psi_z$(k$_x$, k$_y$).

[Equation 25]

$$\phi(x,y,z) = \int\int exp(ik_x x + ik_y y)\left\{ \frac{1}{2}\left[ \phi(k_x,k_y) + \frac{\phi_z(k_x,k_y)}{\sqrt{k_x{}^2+k_y{}^2}} \right] exp(z\sqrt{k_x{}^2+k_y{}^2}) + \frac{1}{2}\left[ \phi(k_x,k_y) - \frac{\phi_z(k_x,k_y)}{\sqrt{k_x{}^2+k_y{}^2}} \right] exp(-z\sqrt{k_x{}^2+k_y{}^2})\right\}dk_x dk_y$$

2. Appareil d'obtention de potentiel selon la revendication 1, dans lequel ø(x, y, z) correspond à une fonction dérivée en différenciant ledit potentiel tridimensionnel une ou plusieurs fois par rapport à la direction Z.

3. Appareil d'obtention de potentiel selon la revendication 1, dans lequel
une épaisseur de film dudit élément de film mince diminue progressivement dans une direction le long d'une surface dudit élément de film mince, la direction étant perpendiculaire à ladite direction longitudinale.

4. Appareil d'obtention de potentiel selon l'une quelconque des revendications 1 à 3, dans lequel
ledit potentiel tridimensionnel est un potentiel dérivé d'un potentiel magnétique, d'un potentiel électrique ou d'un champ de température.

5. Microscope à champ magnétique (1) comprenant :

l'appareil d'obtention de potentiel selon la revendication 1 pour obtenir une fonction dérivée en différenciant un potentiel magnétique une ou plusieurs fois par rapport à la direction Z, en tant que ø(x, y, z),
dans lequel ladite partie de calcul est adaptée à substituer une valeur qui indique une position d'une surface dudit objet ou une position proche de ladite surface en z de ø(x, y, z).

6. Appareil d'inspection (la) utilisant la résonance magnétique nucléaire, comprenant :

l'appareil d'obtention de potentiel selon la revendication 1 pour obtenir une fonction dérivée en différenciant un potentiel magnétique une ou plusieurs fois par rapport à la direction Z, en tant que ø(x, y, z) ; et
des moyens (11, 12) pour induire séquentiellement de la résonance magnétique nucléaire à l'intérieur dudit objet sur une pluralité de plans situés à une pluralité de positions dans la direction Z,
dans lequel ladite partie de commande est adaptée à obtenir ø(x, y, z) lorsque la résonance magnétique nucléaire est induite sur chaque plan inclus dans ladite pluralité de plans, et
ladite partie de calcul est adaptée à substituer une valeur qui indique une position de chaque dit plan en z de ø(x, y, z) obtenu pour chaque dit plan.

7. Procédé d'obtention de potentiel pour, en supposant que ø(x, y, z) est une fonction de potentiel qui indique un potentiel tridimensionnel formé au moins dans la périphérie d'un objet (9, 9a, 9c) en raison de la présence dudit objet, où x, y et z sont des paramètres de coordonnée d'un système de coordonnées rectangulaire défini dans des directions X, Y et Z mutuellement perpendiculaires qui sont réglées pour ledit objet, obtenir ø(x, y, α) sur un plan de mesure (91, 92) qui est réglé en dehors dudit objet et satisfait z = α, où α est une valeur arbitraire, ledit procédé comprenant les étapes consistant à :

a) (S11 à S13) régler une pluralité de zones linéaires qui s'étendent dans une direction longitudinale parallèle audit plan de mesure qui est parallèle à un plan XY de sorte que ladite pluralité de zones linéaires sont agencées dans une direction X' perpendiculaire à ladite direction longitudinale sur ledit plan de mesure, et obtenir, par un capteur s'étendant dans ladite direction longitudinale, une valeur mesurée dérivée dudit potentiel tridimensionnel dans chacune de ladite pluralité de zones linéaires dans un état dans lequel un angle θ formé par la direction Y et ladite direction longitudinale a été changé en une pluralité d'angles ; et
b) (S14) en supposant que x' est un paramètre de coordonnée dans la direction X', où une origine est sur un axe Z, obtenir ø(x, y, a) sur le plan de mesure (91, 92) en utilisant les valeurs mesurées f(x', θ) obtenues dans ladite étape a) à partir de l'Equation 26,

[Equation 26]

$$\phi(x, y, \alpha) = \iint \left| \int f(x', \theta) exp(-ik_{x'}x')dx' \right| exp(ik_{x'}(x\cos\theta + y\sin\theta))k_{x'} dk_{x'} d\theta$$

où $k_{x'}$ est un nombre d'onde dans la direction X',
dans lequel ladite étape a) inclut les étapes consistant à :

a1) (S11) déplacer une partie de mesure (21, 21a à 21c) dans la direction X' par rapport audit objet sur ledit plan de mesure de sorte qu'un balayage est réalisé dans lequel ladite partie de mesure est adaptée à passer sur une zone de mesure dudit objet, ladite partie de mesure étant ledit capteur et étant un élément de film mince qui s'étale dans ladite direction longitudinale et la direction Z et génère un signal dérivé dudit potentiel tridimensionnel ; et
a2) (S12 à S13) obtenir des valeurs mesurées f(x', θ) par des répétitions de ladite étape a1) tout en changeant ledit angle θ formé par l'axe Y et ladite direction longitudinale de ladite partie de mesure en une pluralité d'angles,
dans lequel ledit potentiel tridimensionnel satisfait l'équation de Laplace et ledit plan de mesure satisfait z = 0,
dans lequel ø(x, y, 0) est obtenu en tant que première image bidimensionnelle (71) dans lesdites étapes a) et b), et
dans lequel ledit procédé d'obtention de potentiel comprend les étapes consistant à :

c) (S22) après que ladite partie de mesure est déplacée d'une faible distance dans la direction Z par rapport audit objet, obtenir une image intermédiaire bidimensionnelle (72) en utilisant un procédé similaire à celui utilisé pour obtenir ladite première image ;
d) (S23) obtenir une image de différence entre ladite première image et ladite image intermédiaire, et diviser ladite image de différence par ladite faible distance de manière à obtenir une image différentielle en tant que seconde image ;
e) (S24) réaliser une transformée de Fourier de ø(x, y, 0) servant en tant que ladite première image et $ø_z(x, y, 0)$ servant en tant que ladite seconde image de manière à obtenir $\psi(k_x, k_y)$ et $\psi_z(k_x, k_y)$, où $k_x$ et $k_y$ sont respectivement des nombres d'onde dans la direction X et la direction Y ; et
f) (S25) obtenir ø(x, y, z) à partir de l'Equation 27 en utilisant $\psi(k_x, k_y)$ et $\psi_z(k_x, k_y)$.

[Equation 27]

$$\phi(x,y,z)$$
$$= \int\int exp(ik_x x + ik_y y)\{\frac{1}{2}\left[\phi(k_x,k_y) + \frac{\phi_z(k_x,k_y)}{\sqrt{k_x^2 + k_y^2}}\right]exp(z\sqrt{k_x^2 + k_y^2})$$
$$+ \frac{1}{2}\left[\phi(k_x,k_y) - \frac{\phi_z(k_x,k_y)}{\sqrt{k_x^2 + k_y^2}}\right]exp(-z\sqrt{k_x^2 + k_y^2})\}dk_x dk_y$$

8. Procédé d'obtention de potentiel selon la revendication 7, dans lequel ø(x, y, z) correspond à une fonction dérivée en différenciant ledit potentiel tridimensionnel une ou plusieurs fois par rapport à la direction Z.

9. Procédé d'obtention de potentiel selon l'une quelconque des revendications 7 et 8, dans lequel ledit potentiel tridimensionnel est un potentiel dérivé d'un potentiel magnétique, d'un potentiel électrique ou d'un champ de température.

*FIG. 1*

FIG. 2

EP 2 544 016 B1

*FIG. 3*

*FIG. 4*

```
                                                                    ┌─ 61
    5 ──┌──────────────┐                          ┌──────────────┐
        │    SIGNAL    │                          │   FOURIER    │── 611
        │  PROCESSING  │─────────────────────────▶│ TRANSFORMING │
        │     UNIT     │                          │     PART     │
        └──────────────┘                          └──────────────┘
                │                                          │
                ▼                                          ▼
  612 ─┌──────────────┐                  ┌──────────────────────────┐
       │    FOURIER    │                 │     TWO-DIMENSIONAL      │── 613
       │  TRANSFORMING │                 │  POTENTIAL DISTRIBUTION  │
       │     PART      │                 │     CALCULATING PART     │
       └──────────────┘                  └──────────────────────────┘
               │                                     │
               ▼                                     │
  614 ┌──────────────────────────┐                   │
      │     TWO-DIMENSIONAL       │                   │
      │  POTENTIAL DISTRIBUTION   │                   │
      │     CALCULATING PART      │                   │
      └──────────────────────────┘                   │
                        ◀──────────────────────────────
```

MAGNETIC FIELD DISTRIBUTION IMAGE — 71

44

AUXILIARY MAGNETIC FIELD DISTRIBUTION IMAGE — 72

615 — THREE-DIMENSIONAL POTENTIAL DISTRIBUTION CALCULATING PART

## FIG. 5

```
                          ┌─────────────┐
                          │    START    │
                          └─────────────┘
                                 │
                                 ▼
┌──────────────────────────────────────────────────┐
│     PERFORM SCANNING OF MEASURING PART             │──── S11
└──────────────────────────────────────────────────┘
                                 │
                                 ▼
┌──────────────────────┐      ╱────────────╲
│   CHANGE ANGLE θ     │◄─Yes─│ NEXT SCANNING? │──── S12
└──────────────────────┘      ╲────────────╱
S13                               │ No
                                  ▼
                  ┌─────────────────────────────┐
                  │   OBTAIN φ (x , y , α )      │──── S14
                  └─────────────────────────────┘
                                  │
                                  ▼
                          ┌─────────────┐
                          │     END     │
                          └─────────────┘
```

*FIG. 6*

```
        ┌─────────────┐
        │    START    │
        └─────────────┘
               │
               ▼
┌──────────────────────────────────────────┐      S21
│  OBTAIN MAGNETIC FIELD DISTRIBUTION IMAGE │
└──────────────────────────────────────────┘
               │
               ▼
┌──────────────────────────────────────────────────┐   S22
│ OBTAIN AUXILIARY MAGNETIC FIELD DISTRIBUTION IMAGE│
└──────────────────────────────────────────────────┘
               │
               ▼
┌──────────────────────────────────────────────────┐   S23
│ OBTAIN MAGNETIC FIELD GRADIENT DISTRIBUTION IMAGE │
└──────────────────────────────────────────────────┘
               │
               ▼
┌──────────────────────────────────────────────────┐   S24
│ FOURIER TRANSFORM MAGNETIC FIELD DISTRIBUTION IMAGE│
│  AND MAGNETIC FIELD GRADIENT DISTRIBUTION IMAGE   │
└──────────────────────────────────────────────────┘
               │
               ▼
        ┌─────────────────────┐     S25
        │  OBTAIN φ ( x, y, z )│
        └─────────────────────┘
               │
               ▼
     ┌──────────────────────────────┐   S26
     │  GENERATE MAGNETIC DOMAIN IMAGE│
     └──────────────────────────────┘
               │
               ▼
        ┌─────────────┐
        │     END     │
        └─────────────┘
```

*FIG. 7*

FIG. 8

FIG. 9

FIG. 10

## FIG. 11

*FIG. 12*

FIG. 13

EP 2 544 016 B1

*FIG. 14*

210

21d
21d
21d

21d
21d
21d

X'

Y'

Z

*FIG. 15*

21

21

21

Z

z3
z2
z1

*FIG. 16*

**EP 2 544 016 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006501484 W
- WO 2008123432 A
- JP 2007271465 A